(19) Europäisches Patentamt
European Patent Office
Office européen des brevets

(11) **EP 4 332 947 A1**

(12) **EUROPEAN PATENT APPLICATION**
published in accordance with Art. 153(4) EPC

(43) Date of publication:
**06.03.2024 Bulletin 2024/10**

(51) International Patent Classification (IPC):
*G09F 9/30* (2006.01)     *C03B 23/03* (2006.01)
*C03C 17/00* (2006.01)     *C03C 17/32* (2006.01)
*G02B 1/14* (2015.01)     *G02B 5/30* (2006.01)
*H04M 1/02* (2006.01)

(21) Application number: **23735578.9**

(22) Date of filing: **04.07.2023**

(86) International application number:
**PCT/KR2023/009437**

(87) International publication number:
**WO 2024/014769 (18.01.2024 Gazette 2024/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.07.2022 KR 20220085141**
**13.12.2022 KR 20220174063**

(71) Applicant: **Samsung Electronics Co., Ltd.**
**Suwon-si, Gyeonggi-do 16677 (KR)**

(72) Inventors:
• **OH, Seungteak**
**Suwon-si, Gyeonggi-do 16677 (KR)**
• **LIM, Sunghwan**
**Suwon-si, Gyeonggi-do 16677 (KR)**
• **CHO, Hyunmoon**
**Suwon-si, Gyeonggi-do 16677 (KR)**

(74) Representative: **Gulde & Partner**
**Patent- und Rechtsanwaltskanzlei mbB**
**Wallstraße 58/59**
**10179 Berlin (DE)**

(54) **DISPLAY MODULE AND ELECTRONIC DEVICE COMPRISING SAME**

(57) According to an embodiment of the disclosure, an electronic device may comprise a first housing, a second housing configured to provide a motion relative to the first housing, a flexible display configured to transform in response to the motion of the second housing relative to the first housing, and a display protection layer disposed on one surface of the flexible display facing in a first direction. The display protection layer may include a glass layer including a first flat area having a first thickness and disposed on the first housing, a second flat area disposed on the second housing, and a folding area connecting the first flat area and the second flat area, and a coating layer disposed between the glass layer and the flexible display. The folding area of the glass layer may include a first area having a second thickness different from the first thickness and a second area connecting the first area and the flat area and having a third thickness smaller than the second thickness. The first area may protrude in a second direction opposite to the first direction as compared with the second area.

FIG. 9

**Description**

**[Technical Field]**

Embodiments of the disclosure relate to a display module and an electronic device including the same.

**[Background Art]**

An electronic device may refer to a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, electronic devices may output stored information as voices or images. As electronic devices are highly integrated, and highspeed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling or e-wallet function. These electronic devices have been downsized to be conveniently carried by users.

As mobile communication services spread up to multimedia services, users may use multimedia services as well as voice calls or text messaging, on their electronic device. To rid the user of any inconvenience in using multimedia services, a trend is to pack an electronic device with a larger display panel. Recently, flexible display panel-equipped foldable electronic devices come along.

The above-described information may be provided as background for the purpose of helping understanding of the disclosure. No claim or determination is made as to whether any of the foregoing is applicable as background art in relation to the disclosure.

**[Disclosure of Invention]**

**[Solution to Problems]**

According to an embodiment of the disclosure, an electronic device comprises a first housing, a second housing configured to provide a motion relative to the first housing, a flexible display configured to transform in response to the motion of the second housing relative to the first housing, and a display protection layer disposed on one surface of the flexible display facing in a first direction. The display protection layer includes a glass layer including a flat area, which includes a first flat area having a first thickness and disposed on the first housing, and a second flat area disposed on the second housing, and a folding area connecting the first flat area and the second flat area, and a coating layer disposed between the glass layer and the flexible display. The folding area of the glass layer includes a first area having a second thickness different from the first thickness and a second area connecting the first area and the flat area and having a third thickness smaller than the second thickness. The first area may protrude in a second direction opposite to the first direction as compared with the second area.

According to another embodiment of the disclosure, an electronic device comprises a first housing, a second housing configured to provide a motion relative to the first housing, a flexible display configured to transform in response to the motion of the second housing relative to the first housing, and a display protection layer disposed on one surface of the flexible display facing in a first direction. The display protection layer includes a glass layer including a flat area, which includes a first flat area having a first thickness and disposed on the first housing, and a second flat area disposed on the second housing, and a folding area connecting the first flat area and the second flat area, and a coating layer disposed between the glass layer and the flexible display. The folding area of the glass layer is configured to be at least partially folded or unfolded and include a first area having a second thickness different from the first thickness and a second area connecting the first area and the flat area and having a third thickness smaller than the second thickness. The first area protrudes in a second direction opposite to the first direction as compared with the second area.

**[Brief Description of Drawings]**

FIG. 1 is a block diagram illustrating an electronic device in a network environment according to an embodiment of the disclosure;
FIG. 2 is a front view, side view, and rear view illustrating an electronic device in an unfolded state according to an embodiment of the disclosure;

FIG. 3 is a front view, side view, and rear view illustrating an electronic device in a folded state according to an embodiment of the disclosure;

FIG. 4 is an exploded perspective view illustrating an electronic device according to an embodiment of the disclosure;

FIG. 5 is a front view illustrating an electronic device in an unfolded state and a folded state according to an embodiment of the disclosure;

FIG. 6 is a schematic cross-sectional view taken along line A-A' of the display module of FIG. 5 according to an embodiment of the disclosure;

FIG. 7 is an enlarged cross-reference view illustrating the folding area of FIG. 6 according to an embodiment of the disclosure;

FIG. 8A is a graph illustrating changes in center principal stress according to a reinforcing amount of a first thickness according to an embodiment of the disclosure;

FIG. 8B is a view illustrating comparison between a folding shape of an electronic device according to an embodiment of the disclosure and a folding shape of an electronic device according to a comparative example;

FIG. 9 is a schematic cross-sectional view taken along line A-A' of the display module of FIG. 5 according to an embodiment of the disclosure;

FIG. 10 is a view illustrating comparison between a folding shape of an electronic device of FIG. 9 according to an embodiment of the disclosure and a folding shape of an electronic device according to a comparative example;

FIGS. 11A, 11B, and 11C are cross-sectional views schematically illustrating a partially modified connection portion of the display module of FIG. 9 according to an embodiment of the disclosure;

FIG. 12 is a cross-sectional view schematically illustrating an out-folded state of a display module according to an embodiment of the disclosure;

FIG. 13 is a cross-sectional view schematically illustrating an in-folded state and out-folded state of a display module according to an embodiment of the disclosure;

FIG. 14 is a flowchart illustrating a method for manufacturing the glass layer of FIG. 6 according to an embodiment of the disclosure;

FIG. 15 is a view illustrating a sequence of manufacturing a glass layer according to the manufacturing method of FIG. 14 according to an embodiment of the disclosure;

FIG. 16 is a flowchart illustrating a method for manufacturing the glass layer of FIG. 9 according to an embodiment of the disclosure; and

FIG. 17 is a view illustrating a sequence of manufacturing a glass layer according to the manufacturing method of FIG. 16 according to an embodiment of the disclosure.

**[Mode for the Invention]**

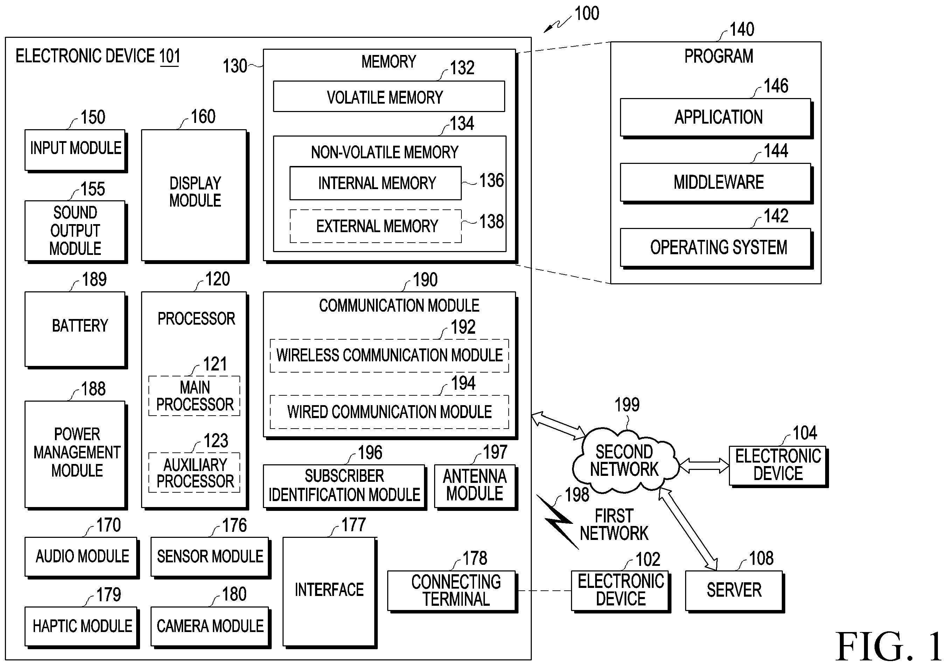

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN))). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

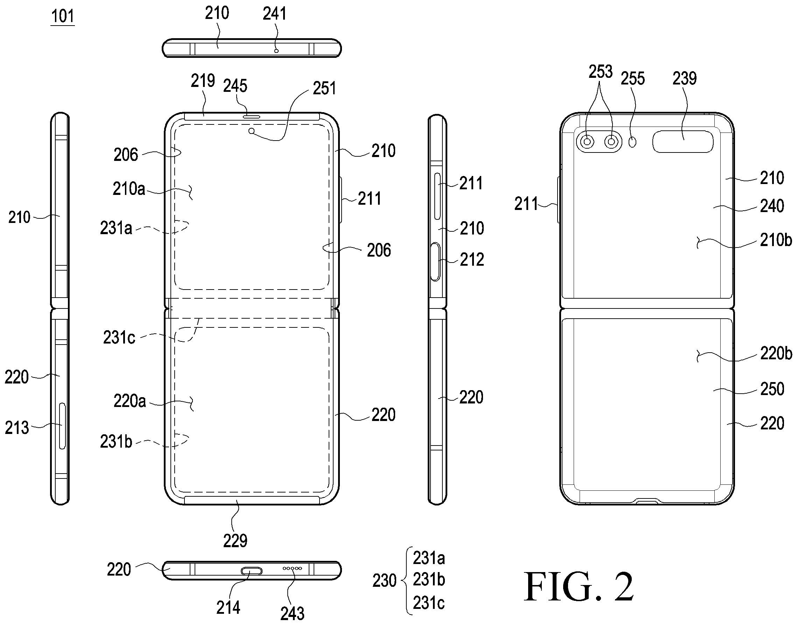

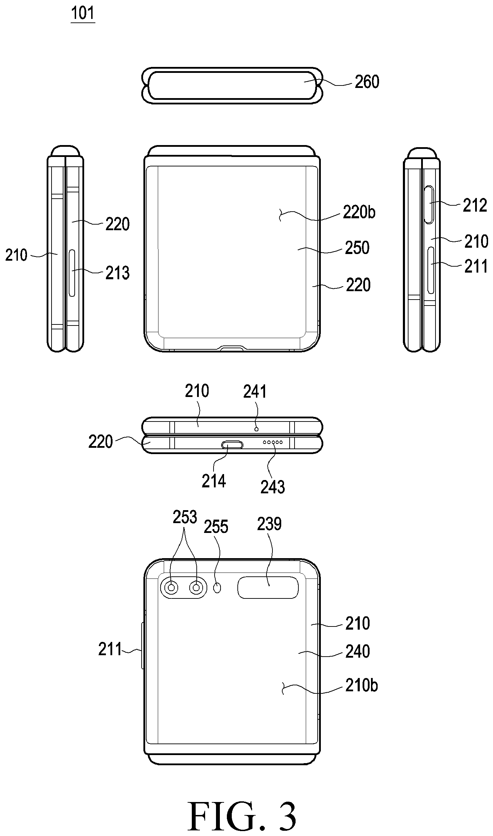

FIG. 2 is a front view, side view, and rear view illustrating an electronic device 100 in an unfolded state according to an embodiment of the disclosure. FIG. 3 is a front view, side view, and rear view illustrating an electronic device 101 in a folded state according to an embodiment of the disclosure.

Referring to FIGS. 2 and 3, according to an embodiment, an electronic device 101 may include a first housing 210, a second housing 220, a flexible or foldable display 230 (hereinafter, simply "display 230") (e.g., the display module 160 of FIG. 1) disposed in the space provided by the first housing 210 and the second housing 220, and a hinge cover 260.

According to an embodiment, the surface on which the display 230 is disposed may be defined as a front surface of the electronic device 101. At least a portion of the front surface of the electronic device 101 may be formed of a substantially transparent front plate (e.g., a glass plate or polymer plate including various coat layers). The opposite surface of the front surface may be defined as a rear surface of the electronic device 101. The rear surface of the electronic device 101 may be formed by a substantially opaque rear plate (hereinafter, referred to as a 'rear cover'). The rear cover may be formed of, e.g., laminated or colored glass, ceramic, polymer, metal (e.g., aluminum, stainless steel (STS), or magnesium), or a combination of at least two thereof. The surface surrounding the space between the front and back surfaces may be defined as a side surface of the electronic device 101. The side surface may be formed by a side bezel structure (or a "side member") that couples to the front plate and the rear plate and includes a metal and/or polymer. According to an embodiment, the rear cover and the side bezel plate may be integrally formed together and include the same material (e.g., a metal, such as aluminum).

The electronic device 101 may include at least one or more of a display 230, audio modules 241, 243, and 245, a sensor module 255, a camera module 253, key input devices 211, 212, and 213, and a connector hole 214. According to an embodiment, the electronic device 101 may omit at least one (e.g., the key input devices 211, 212, and 213) of the components or additionally include another component (e.g., a light emitting device).

According to various embodiments, the display 230 may be a display at least a portion of which may be transformed into a flat or curved surface. According to an embodiment, the display 230 may include a folding area 231c, a first area 231a disposed on one side of the folding area 203 (e.g., an upper side of the folding area 231c of FIG. 2), and a second area 231b disposed on the opposite side of the folding area 231c (e.g., a lower side of the folding area 231c of FIG. 2). However, the segmentation of the display 230 as shown in FIG. 2 is merely an example, and the display 230 may be divided into a plurality of (e.g., four or more, or two) areas depending on the structure or function of the display 200. For example, in the embodiment illustrated in FIG. 2, the display 200 may be divided into the areas by the folding area 231c or folding axis A but, in another embodiment, the display 200 may be divided into the areas with respect to another folding area 231c or another folding axis (e.g., a folding axis perpendicular to the folding axis A).

According to various embodiments, the audio modules 241, 243, and 245 may include a microphone hole 241 and speaker holes 243 and 245. The microphone hole 241 may have a microphone inside to obtain external sounds. According to an embodiment, there may be a plurality of microphones to be able to detect the direction of a sound. The speaker holes 243 and 245 may include an external speaker hole 243 and a phone receiver hole 245. According to an embodiment, the speaker holes 243 and 245 and the microphone hole 241 may be implemented as a single hole, or speakers may be rested without the speaker holes 243 and 245 (e.g., piezo speakers). Various changes may be made to the position and number of microphone holes 241 and speaker holes 243 and 245 according to an embodiment.

According to various embodiments, the camera module 253 may include a first camera device 251 disposed on the first surface 210a of the first housing 210 of the electronic device 101 and a second camera device 253 disposed on the second surface 210b. The electronic device 101 may further include a flash (not shown). The camera devices 251 and 253 may include one or more lenses, an image sensor, and/or an image signal processor. The flash (not shown) may include, e.g., a light emitting diode (LED) or a xenon lamp.

According to various embodiments, the sensor modules 255 may generate an electrical signal or data value corresponding to an internal operating state or external environmental state of the electronic device 101. Although not shown in the drawings, the electronic device 101 may additionally or alternatively include a sensor module (e.g., the sensor module 176 of FIG. 1) other than the sensor module 255 provided on the second surface 210b of the first housing 210. The electronic device 101 may include, as the sensor module, at least one of a proximity sensor, a fingerprint sensor, an HRM sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to various embodiments, the key input devices 211, 212, and 213 may be disposed on a side surface of the foldable housing (e.g., the first housing 210 or the second housing 220). According to another embodiment, the electronic device 101 may exclude all or some of the above-mentioned key input devices 211, 212, and 213 and the excluded key input devices may be implemented in other forms, e.g., as soft keys, on the display 230. In an embodiment, the key input device may be configured to implement key input by a sensor module (e.g., a gesture sensor).

According to various embodiments, the connector hole 214 may be configured to receive a connector (e.g., a USB connector) for transmitting/receiving power and/or data to/from an external electronic device or, additionally or alternatively, a connector for transmitting/receiving audio signals to/from an external electronic device.

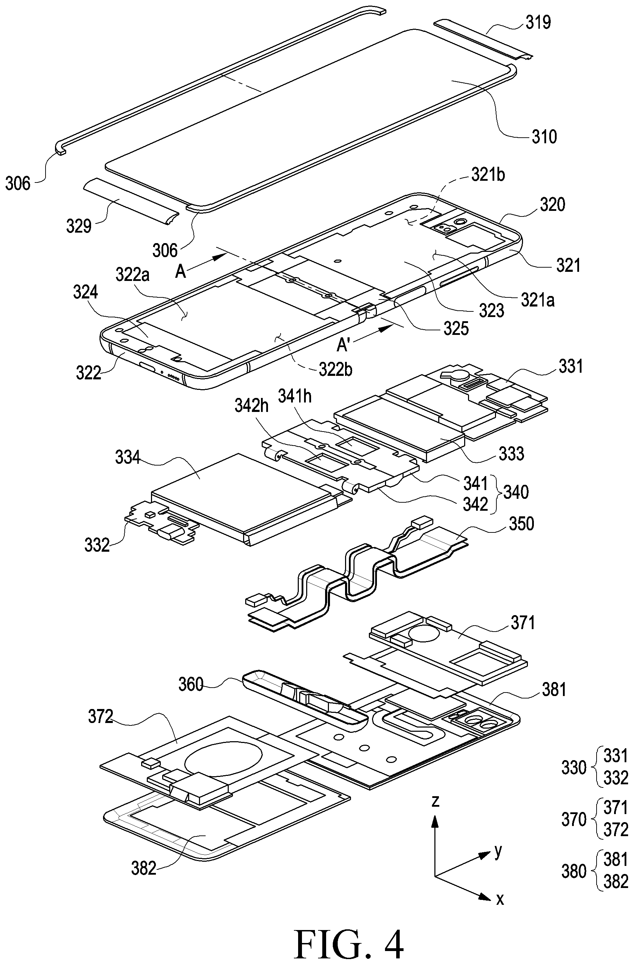

According to various embodiments, a foldable housing may be implemented by a combination of the first housing 210, the second housing 220, the first rear cover 240, the second rear cover 250, and the hinge module (e.g., the hinge structure 340 of FIG. 4). The foldable housing of the electronic device 101 are not limited to the shape and coupling shown but may rather be implemented in other shapes or via a combination and/or coupling of other components. For example, in another embodiment, the first housing 210 and the first rear cover 240 may be integrally formed with each other, and the second housing 220 and the second rear cover 250 may be integrally formed with each other. According to various embodiments of the disclosure, 'housing' may mean a combination of other various components not mentioned and/or a combined configuration thereof. For example, it may be described that a first area 213a of the display 230 forms one surface of the first housing 210 and, in another embodiment, the first area 213a of the display 230 is disposed or attached to one surface of the first housing 210.

According to various embodiments, the first housing 210 may be connected to the hinge structure (e.g., the hinge structure 340 of FIG. 4 described below) and may include a first surface 210a facing in a first direction and a second surface 210b facing in a second direction opposite to the first direction. The second housing 220 may be connected to the hinge structure (e.g., the hinge structure 340 of FIG. 4 described below) and may include a third surface 220a facing in a third direction and a fourth surface 220b facing in a fourth direction opposite to the third direction and may be rotated or pivoted from the first housing 210 about the hinge structure (or folding axis A).

According to various embodiments, the first housing 210 and the second housing 220 may be disposed on two opposite sides (or upper/lower sides) of the folding axis A and may overall have a symmetrical shape with respect to the folding axis A. The angle or distance between the first housing 210 and the second housing 220 may be varied depending on whether the electronic device 101 is in the unfolded state, the folded state, or the partially unfolded (or partially folded) intermediate state. According to an embodiment, the first housing 210 may further include various sensors unlike the second housing 220 but, in the remaining area, the first housing 210 and the second housing 220 may have symmetrical shapes with each other.

According to various embodiments, the first housing 210 and the second housing 220 may at least partially be formed of a metal or non-metallic material with a rigidity selected to support the display 230. The at least a portion formed of the metal material may be provided as a ground plane or radiating conductor of the electronic device 101 and, if provided as the ground plane, it may be electrically connected with a ground line formed on the printed circuit board (e.g., the printed circuit board 330 of FIG. 4).

According to various embodiments, the first rear cover 240 may be disposed on one side (e.g., the upper side in FIG. 2) of the folding axis A, on the rear surface of the electronic device 101, e.g., it may have a substantially rectangular periphery which may be surrounded by the first housing 210 (and/or the side bezel structure). Similarly, the second rear cover 250 may be disposed on the opposite side (e.g., the lower side in FIG. 2) of the folding axis A on the rear surface of the electronic device 101 and its periphery may be surrounded by the second housing 220 (and/or the side bezel structure).

According to various embodiments, the first rear cover 240 and the second rear cover 250 may be substantially symmetrical in shape with respect to the folding axis A. However, the first rear cover 240 and the second rear cover 250 are not necessarily symmetrical in shape. In another embodiment, the electronic device 101 may include the first rear cover 240 and the second rear cover 250 in various shapes. In another embodiment, the first rear cover 240 may be integrally formed with the first housing 210, and the second rear cover 250 may be integrally formed with the second housing 220.

According to various embodiments, the first rear cover 240, the second rear cover 250, the first housing 210, and the second housing 220 may form a space where various components (e.g., the printed circuit board 330 or batteries 333 and 334 of FIG. 4) of the electronic device 101 may be disposed. According to an embodiment, one or more components may be arranged or visually exposed on/through the rear surface of the electronic device 101. For example, at least a portion of a sub display 239 may be visually exposed through the first rear cover 240. In another embodiment, one or more components or sensors may be visually exposed through the first rear cover 240. According to various embodiments, the components or sensors may include a proximity sensor, a rear camera, and/or a flash. Although not separately shown in the drawings, one or more other components or sensors may be visually exposed through the second rear cover 250.

According to various embodiments, the front camera 251 exposed from the front surface of the electronic device 101 through one or more openings or the rear camera 253 exposed through the first rear cover 240 may include one or more lenses, an image sensor, and/or an image signal processor. The flash (not shown) may include, e.g., a light emitting diode (LED) or a xenon lamp. In an embodiment, two or more lenses (an infrared (IR) camera, a wide-angle lens, and a telephoto lens) and image sensors may be disposed on one surface of the electronic device 101.

According to various embodiments, the electronic device 101 may transform into a folded state of the display or an unfolded state of the display. For example, the first housing 210 and the second housing 220 may be pivoted about each other between the folded state in which the housings 210 and 220 face each other and a state (e.g., the state shown in FIG. 2, an unfolded state of the terminal) in which the housings 210 and 220 are unfolded at a designated angle from the folded state.

According to various embodiments, the electronic device 101 may be implemented as two types, 'in-folding' in which the first area 231a and the second area 231b are folded to face each other, and 'out-folding' in which the first area 231a and the second area 231b are folded in face in opposite directions. For example, in the in-folding folded state, the first area 231a and the second area 231b may be substantially hidden and, in the fully unfolded state, the first area 231a and the second area 231b may be disposed to face substantially in the same direction. As another example, in the out-folding folded state, the first area 231a and the second area 231b are disposed to face in opposite directions, exposed to the outside and, in the fully unfolded state, the first area 231a and the second area 231b may be disposed to face substantially in the same direction.

According to various embodiments, the display 230 may include a display panel (not shown) and a window member (not shown) and may be formed of a flexible material. Although not separately shown, it will be appreciated by one of ordinary skill in the art that the display 230 or display panel includes various layers, such as a light emitting layer, a substrate(s) for encapsulating the light emitting layer, an electrode or wiring layer, and/or adhesive layer(s) for bonding different layers. When the display 230 (e.g., the folding area 231c) is deformed into a flat or curved shape, a relative displacement may occur between the layers constituting the display 230. The relative displacement due to the deformation of the display 203 may increase as it is farther away from the folding axis A and/or as the thickness of the display 230 increases.

According to various embodiments, the window member, e.g., the thin film plate, may serve as a protective film to protect the display panel. As a protection film, a thin film plate may be formed of a material that protects the display panel from external impact, is robust against scratches, and causes fewer creases in the folding area 231c when the housings 210 and 220 are repeatedly folded and unfolded. For example, the material of the thin film plate may include a clear polyimide (CPI) film or ultra-thin glass (UTG).

Referring to FIG. 3, the hinge cover 260 may be disposed between the first housing 210 and the second housing 220 to hide the internal components. According to an embodiment, the hinge cover 260 may be hidden by a portion of the first housing 210 and second housing 220 or be exposed to the outside depending on the state (e.g., the unfolded state (flat state), intermediate state, or folded state) of the electronic device 101.

According to an embodiment, as shown in FIG. 2, in the unfolded state of the electronic device 101, the hinge cover 260 may be hidden, and thus not exposed, by the first housing 210 and the second housing 220. As another example, as shown in FIG. 3, in the folded state (e.g., a fully folded state) of the electronic device 101, the hinge cover 260 may be exposed to the outside between the first housing 210 and the second housing 220. As another example, in an intermediate state in which the first housing 210 and the second housing 220 are folded with a certain angle, the hinge cover 260 may be partially exposed to the outside between the first housing 210 and the second housing 220. However, in this case, the exposed area may be smaller than that in the completely folded state. In an embodiment, the hinge cover 260 may include a curved surface.

According to various embodiments, the electronic device 101 may further include a protection member(s) 206 or ornamental covers 219 and 229 disposed at at least a portion of the edge of the display 230 on the front surface (e.g., the front surface 210a or the third surface 220a). The protection member 206 or ornamental covers 219 and 229 may prevent at least a portion of the edge of the display 230 from contacting a mechanical structure (e.g., the first housing 210 or the second housing 220) and provide a decorative effect to the exterior of the electronic device 101.

FIG. 4 is an exploded perspective view illustrating an electronic device 101 (e.g., the electronic device 101 of FIG. 2) according to various embodiments of the disclosure.

Referring to FIG. 4, in various embodiments, the electronic device 101 may include a display 310 (e.g., the display 230 of FIG. 2), a foldable housing (e.g., the first housing 321 and the second housing 322, the first housing 210 and second housing 220 of FIG. 2), a printed circuit board 330, a hinge structure 340, a flexible connection member 350, a hinge cover 360 (e.g., the hinge cover 260 of FIG. 3), an antenna module 370, and a rear cover 380. In an embodiment, the electronic device 101 may include at least one protection member 306 and/or at least one ornamental cover 319 or 329. The protection member 306 and/or the ornamental covers 319 and 329 may be disposed adjacent to at least a portion of the circumference of the display 310 (e.g., the display 230 of FIG. 2).

According to various embodiments, the display 310 may be exposed through a majority of the front surface of the electronic device 101. According to an embodiment, the shape of the display 310 may be formed to be substantially the same as the shape of the periphery of the front surface of the electronic device 101.

In FIG. 4, 'Y' may mean a length direction of the electronic device 101 in the second state. Further, in an embodiment of the present invention, '+Y' may mean the upward direction of the electronic device 101 around the folding axis A of the electronic device 101, and '-Y' may mean the downward direction of the electronic device 101 around the folding axis A of the electronic device 101.

According to various embodiments, the foldable housing of the electronic device 101 may include the first housing 321 and the second housing 322. According to an embodiment, the first housing 321 may include a first surface 321a and a second surface 321b facing in a direction opposite to the first surface 321a. The second housing 322 may include a third surface 322a and a fourth surface 322b facing in a direction opposite to the third surface 322a. The electronic device 101 or the foldable housing 321 and 322 may additionally or alternatively include a bracket assembly 325. The bracket assembly 325 may include a first bracket assembly 323 disposed in the first housing 321 and a second bracket assembly 324 disposed in the second housing 322. At least a portion of the bracket assembly 325, e.g., at least a portion of the first bracket assembly 323 and at least a portion of the second bracket assembly 324, may serve as a plate for supporting the hinge structure 340.

According to various embodiments, various electric components may be disposed on the printed circuit board 330. For example, a processor (e.g., the processor 120 of FIG. 1), a memory (e.g., the memory 130 of FIG. 1), and/or an interface (e.g., the interface 177 of FIG. 1) may be mounted on the printed circuit board 330. The processor may include one or more of, e.g., a central processing unit, an application processor, a graphic processing device, an image signal processing, a sensor hub processor, or a communication processor. The memory may include, e.g., a volatile or non-volatile memory. The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to various embodiments, the printed circuit board 330 may include a first printed circuit board 331 disposed on the side of the first bracket assembly 323 and a second printed circuit board 332 disposed on the side of the second bracket assembly 324. The first printed circuit board 331 and the second printed circuit board 332 may be disposed inside the space formed by the foldable housing 321 and 322, the bracket assembly 325, the first rear cover 381 and/or the second rear cover 382. Components for implementing various functions of the electronic device 101 may be disposed on the first printed circuit board 331 and the second printed circuit board 332. For example, a processor may be disposed on the first printed circuit board 331, and an audio interface may be disposed on the second printed circuit board 332.

According to various embodiments, batteries 333 and 334 may be disposed adjacent to the printed circuit board 330 to supply power to the electronic device 101. At least a portion of the batteries 333 and 334 may be disposed on substantially the same plane as the printed circuit board 330. According to an embodiment, a first battery 333 may be disposed adjacent to the first printed circuit board 331, and a second battery 334 may be disposed adjacent to the second printed circuit board 332. The batteries 333 and 334 may be a device for supplying power to at least one component of the electronic device 101. The battery 189 may include, e.g., a primary cell which is not rechargeable, a secondary cell which is rechargeable, or a fuel cell. The batteries 333 and 334 may be integrally or detachably disposed inside the foldable housing 321 and 322.

According to various embodiments, the hinge structure 340 may be a component to provide a folding axis (e.g., the folding axis A of FIG. 2) and rotatably connect or couple the foldable housing 321 and 322 and/or the bracket assembly 325. The hinge structure 340 may include a first hinge structure 341 disposed on the side of the first printed circuit board 331 and a second hinge structure 342 disposed on the side of the second printed circuit board 332. The hinge structure 340 may be disposed between the first printed circuit board 331 and the second printed circuit board 332. According to an embodiment, the hinge structure 340 may be formed substantially integrally with at least a portion of the first bracket assembly 323 and at least a portion of the second bracket assembly 324.

According to various embodiments, a 'housing structure' may include the foldable housing 321 and 322 and may denote one resultant from assembling and/or combining at least one component disposed in the foldable housing 321 and 322. The housing structure may include a first housing structure and a second housing structure. For example, a component assembled to include at least one component among the first housing 321 and the first bracket assembly 323, the first printed circuit board 331, and the first battery 333 disposed inside the first housing 321 may be referred to as the 'first housing structure.' As another example, a component assembled to include at least one component among the second housing 322 and the second bracket assembly 324, the second printed circuit board 332, and the second battery 334 disposed inside the second housing 322 may be referred to as the 'second housing structure.' However, it should be noted that the 'first housing structure and the second housing structure' are not limited to the addition of the above-described components, but may add or omit various other components.

According to various embodiments, the flexible connection member 350 may be, e.g., a flexible printed circuit board (FPCB). The flexible connection member 350 may connect various electrical elements disposed on the first printed circuit board 331 and the second printed circuit board 332. To this end, the flexible connection member 350 may be disposed to cross the 'first housing structure' and the 'second housing structure'. According to an embodiment, the flexible connection member 350 may be disposed to cross at least a portion of the hinge structure 340. According to an embodiment, the flexible connection member 350 may be configured to connect the flexible printed circuit board 331 and the second printed circuit board 332 across the hinge structure 340 along a direction parallel to, e.g., the y axis of FIG. 4. As another example, the flexible connection member 350 may extend or be disposed through the openings 341h and 342h formed in the hinge structure 340. In this case, a portion of the flexible connection member 350 may be disposed over one side (e.g., upper portion) of the first hinge structure 341, and another portion of the flexible connection member 350 may be disposed over one side (e.g., upper portion) of the second hinge structure 342. Another portion of the flexible connection member 350 may be disposed on the other side (e.g., lower portion) of the first hinge structure 341 and the second hinge structure 342. A space (hereinafter, referred to as a 'wiring space') surrounded by at least a portion of the first hinge structure 341, at least a portion of the second hinge structure 342, and at least a portion of the hinge cover 360 may be formed in a position adjacent to the first hinge structure 341 and the second hinge structure 342. According to an embodiment, at least a portion of the flexible connection member 350 may be disposed in the wiring space.

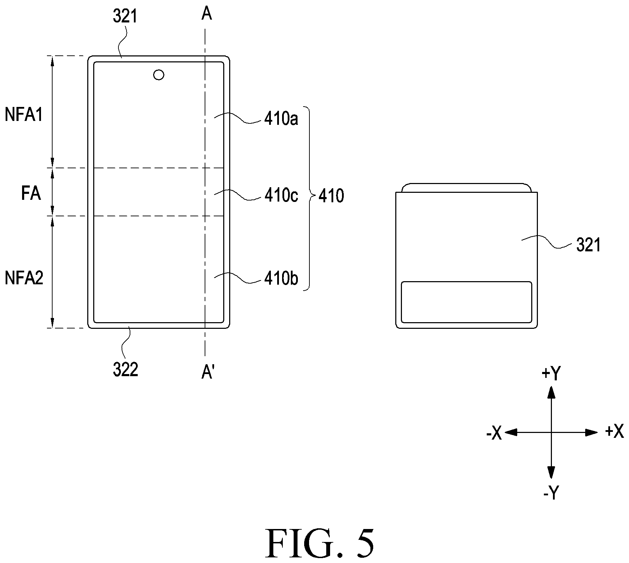

The configuration of the flexible connection member 350 is described in more detail in connection with FIGS. 5 to 19.

According to various embodiments, the hinge cover 360 may be a component that covers at least a portion of the hinge structure 340 or the wiring space. In an embodiment, the hinge cover 360, together with the hinge structure 340, may form the wiring space and protect components (e.g., at least a portion 350c of the flexible connection member 350) disposed in the wiring space from external impact. According to an embodiment, the hinge cover 360 may be disposed between the first housing 321 and the second housing 322. In the electronic device 101 which is of an in-folding type, the hinge cover 360 may be at least partially concealed by the foldable housing 321 and 322. For example, in the folded state, the hinge cover 360 may be visually exposed to the external space between the rear surface (e.g., the first rear cover 381) of the first housing 321 and the rear cover (e.g., the second rear cover 382) of the second housing 322 and, in the unfolded state, the hinge cover 360 may be substantially received inside the first housing 321 or the second housing 322 to be visually concealed.

According to various embodiments, the antenna module 370 (e.g., the antenna module 197 of FIG. 1) may be disposed between the rear cover 380 and the batteries 333 and 334. According to an embodiment, the antenna module 370 may include a first antenna module 371 disposed on the side of the first housing 321 and a second antenna module 372 disposed on the side of the second housing 322. The antenna module 370 may include, e.g., a near field communication (NFC) antenna, a wireless charging antenna, and/or a magnetic secure transmission (MST) antenna, performing short-range communication with an external device or wirelessly transmitting/receiving power required for charging. According to another embodiment, an antenna structure may be formed by a portion or combination of the side bezel structure of the foldable housing 321 and 322 and/or bracket assembly.

According to various embodiments, the rear cover 380 may include a first rear cover 381 and a second rear cover 382. The rear cover 380 may be combined with the foldable housing 321 and 322 to protect the above-described components (e.g., the printed circuit board 330, the batteries 333 and 334, the flexible connection member 350, and the antenna structure 370) disposed in the foldable housing 321 and 322. As described above, the rear cover 380 may be configured substantially integrally with the foldable housing 321 and 322.

According to various embodiments, the protection member 306 and/or the ornamental covers 319 and 329 (e.g., the protection member 206 and/or the ornamental covers 219 and 229 of FIG. 2) may protect at least a portion of the edge of the display 310. In an embodiment, the protection member 306 may be disposed between the edge of the display 310 and the inner wall of the first housing 321 and/or between the edge of the display 310 and the inner wall of the second housing 322 to prevent direct contact between the edge of the display 310 and the inner wall of the foldable housing 321 and 322. In another embodiment, the ornamental cover 319 may be disposed on at least one of the first housing 310 and the second housing 320 and may be disposed to cover a portion of the edge of the display 310.

FIG. 5 is a front view illustrating an electronic device (e.g., the electronic device 101 of FIG. 2) in an unfolded state and a folded state according to an embodiment of the disclosure.

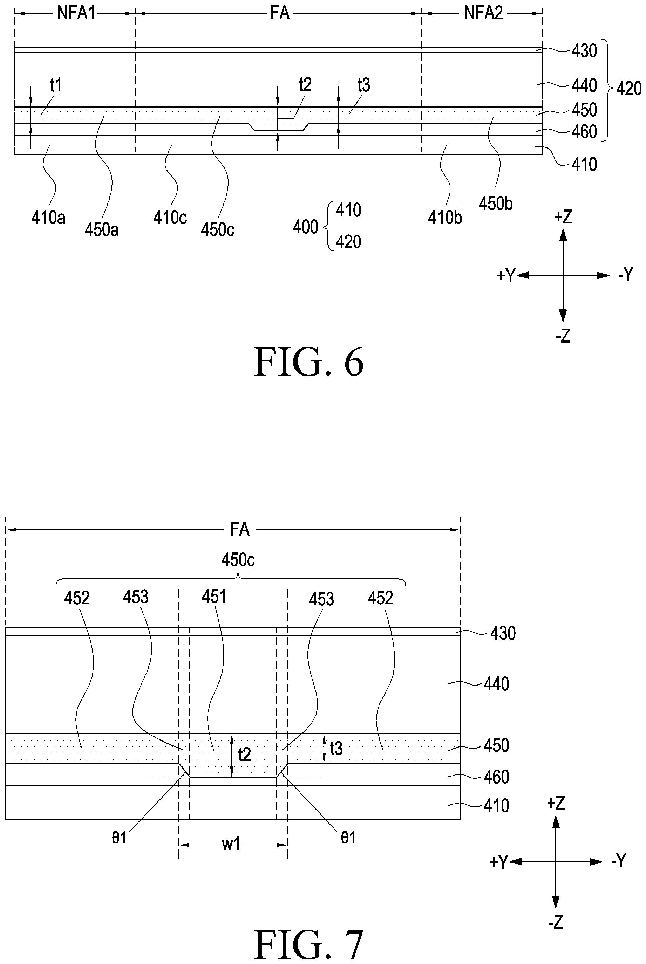

Referring to FIG. 5, in an embodiment of the disclosure, the electronic device 101 may include a first housing 321, a second housing 322 configured to provide a motion relative to the first housing 321, and a display module (e.g., the display module 400 of FIG. 6). Referring to FIG. 5, the display module 400 may include a flexible display 410 configured to transform in response to the motion of the second housing 322 relative to the first housing 321, and a display protection layer (e.g., the display protection layer 420 of FIG. 6) disposed on the flexible display 410.

Referring to FIG. 5, the configuration of the electronic device 101, the housings 321 and 322, and the display module 400 of FIG. 5 may be identical in whole or part to the configuration of the electronic device 101, the foldable housing (e.g., the first housing 321 and the second housing 322), and the display 310 of FIG. 4. The structure of FIG.

5 may be selectively coupled to the structure of FIG. 4.

In FIG. 5, "X" may be defined and interpreted as a width direction in the unfolded state of the electronic device 101, and "Y" may be defined and interpreted as a length direction of the electronic device 101. In an embodiment of the present invention, 'X' may mean a 1-1th direction (+X direction) and a 1-2th direction (-X direction). In an embodiment of the present invention, 'Y' may mean a 2-1th direction (+Y direction) and a 2-2th direction (-Y direction).

Referring to FIG. 5, a flexible electronic device is exemplarily illustrated as an embodiment of the electronic device 101. However, the disclosure is not limited thereto, and may be applied to various electronic devices requiring a flexible display such as a foldable display, a rollable display, and a slidable display. The display module 400 according to an embodiment of the disclosure may be used in various electronic devices such as large-sized electronic devices such as televisions or external signage, as well as small or medium-sized electronic devices such as mobile phones, personal computers, notebook computers, personal digital terminals, car navigation units, game consoles, portable electronic devices, wristwatch-type electronic devices, or cameras.

According to an embodiment, the flexible display 410 displaying an image may be exposed through a substantial portion of the front surface of the electronic device 101. In an embodiment, the shape of the flexible display 410 may be formed to be substantially the same as the outer shape of the electronic device 101. For example, the shape of the flexible display 410 may be substantially the same as the shape of the housings 321 and 322 of the electronic device 101. The flexible display 410 may be disposed parallel to the X-axis or the Y-axis perpendicular to the X-axis.

The display module 400 may be divided into a first non-folding area NFA1, a second non-folding area NFA2 disposed to be spaced apart from the first non-folding area NFA1, and a folding area FA disposed between the first non-folding area NFA1 and the second non-folding area NFA2. For example, referring to FIG. 5, the display module 400 may include a first non-folding area NFA1, a folding area FA extending from the first non-folding area NFA1 in the Y-axis direction, and a second non-folding area NFA2 extending from the folding area FA in the Y-axis direction.

The folding area FA of the flexible display 410 may be folded along a folding axis. The folding axis may be substantially the same direction as the X-axis direction.

According to an embodiment, the flexible display 410 may be a display in which at least a partial area thereof may transform into a flat surface or a curved surface. According to an embodiment, the flexible display 410 may include a first display area 410a corresponding to the first non-folding area NFA1 of the display module 400, a second display area 410b corresponding to the second non-folding area NFA2 of the display module 400, and a third display area 410c corresponding to the folding area FA of the display module 400. For example, the first display area 410a may be disposed on one side (e.g., the +Y-side direction of FIG. 5) of the third display area 410c, and the second display area 410b may be disposed on the other side (e.g., the -Y-side direction of FIG. 5) of the third display area 410c. However, the segmentation of the flexible display 410 as shown in FIG. 5 is merely an example, and the flexible display 410 may be divided into a plurality of (e.g., four or more, or two) areas depending on the structure or function of the display 200. For example, in the embodiment illustrated in FIG. 5, the area of the flexible display 410 may be divided by the third display area 410c, but in another embodiment, the area of the flexible display 410 may be divided based on another folding area or another folding axis. According to an embodiment, the third display area 410c may be folded along the folding axis such that the display surface of the first display area 410a and the display surface of the second display area 410b face each other. As described above, the electronic device 101 may be folded such that the display surface of the first display area 410a and the display surface of the second display area 410b face each other, and this is defined as inner folding. Although not illustrated, the electronic device 101 may be folded along the folding axis such that the display surface of the first display area 410a and the display surface of the second display area 410b face outward, and this may be defined as outer folding.

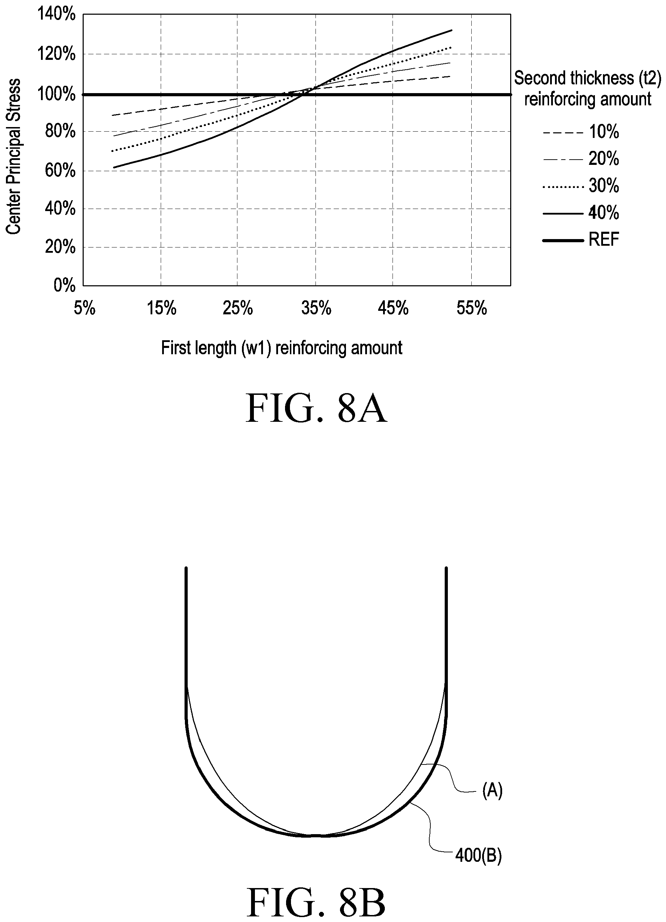

FIG. 6 is a schematic cross-sectional view taken along line A-A' of the display module 400 of FIG. 5 according to an embodiment of the disclosure. FIG. 7 is an enlarged cross-reference view illustrating the folding area FA of FIG. 6 according to an embodiment of the disclosure. FIG. 8A is a graph illustrating changes in center principal stress according to a reinforcing amount of a first thickness according to an embodiment of the disclosure. FIG. 8B is a view illustrating comparison between a folding shape of an electronic device 101 according to an embodiment of the disclosure and a folding shape of a general electronic device 101.

Referring to FIGS. 6 to 8B, in an embodiment, the display module 400 of the electronic device 101 may include a flexible display 410 and a display protection layer 420 disposed on the flexible display 410. The display protection layer 420 may include a coating layer 460 disposed on the flexible display 410, a glass layer 450 disposed on the coating layer 460, a soft protection film 440 disposed on the glass layer 450, and an outermost coating layer 430 disposed on the protection film 440.

Referring to FIGS. 6 to 8B, the configuration of the electronic device 101, the housings 321 and 322, and the display module 400 of FIG. 5 may be identical in whole or part to the configuration of the configuration of the electronic device 101, the housings 321 and 322, and the display module 400 of FIG. 5. The structure of FIGS. 6 to 8B may be selectively coupled to the structure of FIG. 5.

In FIGS. 6 to 8B, "Z" may be defined and interpreted as a thickness direction of the electronic device 101, and "Y" may be defined and interpreted as a length direction of the electronic device 101. In an embodiment of the present invention, 'Z' may mean a 3-1th direction (+Z direction) and a 3-2th direction (-Z direction). In an embodiment of the present invention, 'Y' may mean a 2-1th direction (+Y direction) and a 2-2th direction (-Y direction).

In an embodiment, when the electronic device is folded, compression and/or tensile stress may be generated in soft layers constituting the display module 400. Layers formed of polymer are vulnerable to plastic deformation, so that long-term or repetitive folding or a high temperature and/or high humidity environment may result in permanent deformation. This may leave creases, which may be visually and/or tactilely identified, in the folding area FA of the display module 400.

In the electronic device of the comparative example, the hinge structure of the electronic device of the comparative example may be modified to prevent creases in the folding area of the display module of the comparative example, thereby relieving stress applied to the display of the comparative example. When the hinge structure is modified, the bending radius of the display of the comparative example may increase, thereby increasing the thickness of the electronic device of the comparative example. When a dumbbell hinge is used to not increase the thickness of the electronic device of the comparative example, the waterproof and/or dustproof functions of the electronic device of the comparative example may be deteriorated because the movement of the central portion of the display of the comparative example is inevitable during driving.

According to an embodiment of the present invention, the glass layer 450 of the display protection layer 420 may be a foldable thin film glass. For example, the glass layer 450 may include a soft material such as polyimide (PI) or polyethylene terephthalate (PET) to protect the flexible display 410.

According to an embodiment of the disclosure, the glass layer 450 of the display protection layer 420 may include flat areas 450a and 450b including a first flat area 450a disposed on the first housing 321 and a second flat area 450b disposed on the second housing 322, and a folding area 450c configured to be at least partially folded or unfolded and connecting the first flat area 450a and the second flat area 450b.

According to an embodiment of the present invention, the flat areas 450a and 450b of the glass layer 450 may include, e.g., a first flat area 450a disposed in an area corresponding to the first non-folding area NFA1 of the display module 400 and a second flat area 450b disposed in an area corresponding to the second non-folding area NFA2 of the display module 400. For example, the flat areas 450a and 450b may include a first flat area 450a disposed on the first display area 410a of the flexible display 410 and a second flat area 450b disposed on the second display area 410b of the flexible display 410.

According to an embodiment of the present invention, the flat areas 450a and 450b of the glass layer 450 may have a substantially single thickness. The thickness of the flat areas 450a and 450b may be defined as a first thickness t1. According to an embodiment, the first thickness t1 may be 30 $\mu$m or more and 34 $\mu$m or less.

According to an embodiment of the present invention, the folding area 450c of the glass layer 450 may include a plurality of areas having different thicknesses. The thickness of a central portion of the folding area 450c of the glass layer 450 may be locally larger. At least a portion of the folding area 450c of the glass layer 450 may be configured to be folded or unfolded, and may include a first area 451 positioned in a central portion of the folding area 450c and a second area 452 extending from the first area 451 and connecting the first area 451 and the flat area. For example, the first area 451 may have a second thickness t2 different from the first thickness t1. The second area 452 may have a third thickness t3 that is smaller than the second thickness t2. For example, the first area 451 may protrude in the 3-2th direction (e.g., the -Z direction of FIG. 6) as compared to the second area 452. For example, the third thickness t3 may be substantially the same as the first thickness t1 of the flat area. For example, the first thickness t1 and/or the third thickness t3 may be about 30 $\mu$m or more and about 34 $\mu$m or less. For example, the first thickness t1 and/or the third thickness t3 may be about 31 $\mu$m. For example, the second thickness t2 may be 36 $\mu$m or more and 44 $\mu$m or less. For example, the second thickness t2 may be about 40 $\mu$m. When the thickness of the central portion is locally increased, tensile and/or compressive stress and deformation concentrated in the central portion during folding may be dispersed without increasing the resistance to bending, thereby mitigating creases in the central portion of the electronic device 101.

According to an embodiment, referring to FIG. 7, the second thickness t2 of the first area 451 of the glass layer 450 may be larger than the third thickness t3. When the thickness of the second thickness t2 is relatively larger than the thickness of the third thickness t3, the repulsive force of the glass layer 450 against bending may increase, thereby affecting the folding of the electronic device 101. When the second thickness t2 is not relatively different from the third thickness t3, the effect of relieving stress may be weak. According to an embodiment, the width length (e.g., the length in the Y-axis direction of FIG. 7) of the folding area FA may be, e.g., about 1 mm or more and 20 mm or less. The width length (e.g., the length in the Y-axis direction of FIG. 7) of the folding area FA may vary depending on the type, size, and/or design of the electronic device 101. According to an embodiment, referring to FIG. 7, the width length (e.g., the length in the Y-axis direction of FIG. 7) of the first area 451 of the glass layer 450 may be a portion of the folding area 450c. For example, it may be local. For example, it may be a first length w1. For example, when the second thickness t2 is about 40 $\mu$m, the first length w1 may be about 1 mm or more and 2 mm or less. When the first length w1 is relatively large, the repulsive force of the glass layer 450 against bending may increase, thereby affecting the folding of the electronic device 101. When the first length w1 is relatively small, the effect of forming a constant radius of curvature by dispersing stress may be weak.

Referring to FIG. 8B, a comparison in bending shape is made between when bending the glass layer B in which a portion of the folding area 450c is locally thick according to an embodiment of the present invention and when bending the glass layer A of the electronic device according to the comparative example. The radius of curvature may be larger when bending the glass layer B in which a portion of the folding area 450c is locally thick according to an embodiment of the present invention than when bending the glass layer A of the electronic device 101 according to the comparative example. For example, when bending the glass layer A of the electronic device 101 of the comparative example, it is bent in an oval shape with a relatively small radius of curvature and, when bending the glass layer B in which a portion of the folding area 450c is locally thick, it may be bent in a circular shape with a relatively large radius of curvature.

[Equation 1]

$$\sigma = \mathrm{E}\frac{y}{\rho}$$

[Table 1]

| | A | B | Relaxation rate (%) |
|---|---|---|---|
| Maximum principal stress (MPa) | 949.4 | 924.7 | 2.6 |
| Strain (1E-3) | 12.52 | 12.19 | |

Equation 1 is the relationship between the radius of curvature $\rho$ and the stress $\sigma$. The stress $\sigma$ may refer to the force generated in the material against a load (external force) applied to the material, such as compression, tension, bending, or torsion, applied to the material, corresponding to the magnitude of the load, or the force to keep the original shape of the material against such a load. The stress $\sigma$ may be the cause of creases. In Equation 1, E is the Young's modulus of the material, and y is the distance between the neutral axis and the surface (1/2 of the material thickness). Referring to Equation 1, since the radius of curvature $\rho$ and the stress $\sigma$ have a reciprocal relationship, when the radius of curvature increases, the applied stress may be reduced.

Referring to FIG. 8B, as compared to the electronic device of the comparative example, the electronic device 101 including the glass layer 450 in which a portion of the folding area 450c is locally thick according to an embodiment of the present invention has a large radius of curvature and is given a relatively small stress and/or strain. Table 1 is a table comparing the maximum principal stress and the maximum strain of the central portion of the electronic device 101 according to bending of the electronic device 101 according to FIG. 8B. The maximum principal stress may be the maximum normal stress value. It may be identified that the central stress $\sigma$ of the glass layer B in which a portion of the folding area 450c is locally thick according to an embodiment of the present invention is alleviated as compared to the stress of the glass layer A of the electronic device of the comparative example. For example, the stress in the central stress $\sigma$ of the glass layer B in which a portion of the folding area 450c is locally thick according to an embodiment of the present invention, may be reduced by about 1% or more and 5% or less as compared to the stress of the glass layer A of the electronic device of the comparative example. For example, the central stress $\sigma$ of the glass layer B in which a portion of the folding area 450c is locally thick according to an embodiment of the present invention may be reduced by about 3% as compared to the stress of the glass layer A of the electronic device of the comparative example.

FIG. 8A is a graph illustrating changes in center principal stress according to a reinforcing amount of a first length w1. The X-axis denotes the reinforcing amount of the first length w1. The reinforcing amount of the first length w1 may be a ratio of the first length w1 to the folding area 450c. A total of four graphs are shown according to the reinforcing amount of the second thickness t2. The reinforcing amount of the second thickness t2 may be a rate at which the second thickness t2 is increased relative to the first thickness t1.

Referring to FIG. 8A, it may be identified that as the reinforcing amount of the first length w1 decreases, the center principal stress decreases. For example, when the reinforcing amount of the first length w1 is 40% or less, it may be identified that the center principal stress is reduced as compared to the electronic device REF of the comparative example. However, when the reinforcing amount of the first length w1 is 40% or more, it may be identified that the center principal stress increases compared to the electronic device REF of the comparative example. When the reinforcing amount of the first length w1 is 40% or more, the repulsive force of the glass layer (e.g., the glass layer 450 of FIG. 7) against bending may increase, and thus the principal stress may increase. Thus, it may be identified that the reinforcing amount of the first length w1 is 40% or less. Thus, it may be identified that, e.g., 35% or less is appropriate as the reinforcing amount of the first length w1.

Referring to FIG. 8A, it may be identified that as the reinforcing amount of the second thickness t2 increases, the principal stress reduction effect is more noticeable. For example, when the reinforcing amount of the second thickness t2 is 10%, the principal stress reduction effect may not be large. For example, when the reinforcing amount of the second thickness t2 is 10%, the reduction rate of the center principal stress may be 20% or less. For example, when the reinforcing amount of the second thickness t2 is 40%, it may be identified that the center principal stress reduction effect is relatively large. For example, when the reinforcing amount of the second thickness t2 is 40%, the reduction rate of the center principal stress may be about up to 60%. Thus, it may be identified that, e.g., 20% or more and 50% or less is appropriate as the reinforcing amount of the second thickness t2. Thus, it may be identified that, e.g., 35% or more and 45% or less is appropriate as the reinforcing amount of the second thickness t2.

According to an embodiment, referring to FIG. 7, the folding area 450c of the glass layer 450 may further include a connection portion 453 connecting a plurality of areas having different thicknesses. For example, the folding area 450c of the glass layer 450 may further include a connection portion 453 connecting the first area 451 and the second area 452. The connection portion 453 may connect the first area 451 having the second thickness t2 and the second area 452 having the third thickness t3. The connecting portion 453 may be disposed between the first area 451 having the second thickness t2 and the second area 452 having the third thickness t3. According to an embodiment, the connection portion 453 may include a straight line having an inclination according to the first angle θ1. The connection portion 453 may be positioned between a plurality of areas having different thicknesses and may have an inclination according to the first angle θ1. The first angle θ1 may be, e.g., an acute angle. The first angle θ1 may be, e.g., about 0 degrees or more and 90 degrees or less. However, the form and shape of the connection portion 453 are not limited to the above embodiment, and various changes may be made to the design.

According to an embodiment, the coating layer 460 may correspond to the shape of the glass layer 450. For example, when the thickness of the glass layer 450 increases, the thickness of the coating layer 460 may decrease, and when the thickness of the glass layer 450 decreases, the thickness of the coating layer 460 may increase. For example, the thickness of the coating layer 460 in the portion corresponding to the first area 451 of the glass layer 450 may be smaller than the thickness of the coating layer 460 in the portion corresponding to the second area 452, which is thinner than the first area 451 of the glass layer 450. According to an embodiment, the total thickness of the combined layer of the coating layer 460 and the glass layer 450 may be substantially constant. According to an embodiment, the overall thickness may be maintained constant by removing the thickness difference of the coating layer 460 by the thickness difference of the glass layer 450 having a plurality of thicknesses. According to an embodiment, the coating layer 460 may be a coating for filling. For example, the coating layer 460 may include an adhesive material such as an adhesive or resin.

According to an embodiment, the electronic device 101 may further include the outermost coating layer 430 at the outermost portion of the display protection layer 420. The outermost coating layer 430 may be a protection film such as a hard coating or an anti-fingerprint coating.

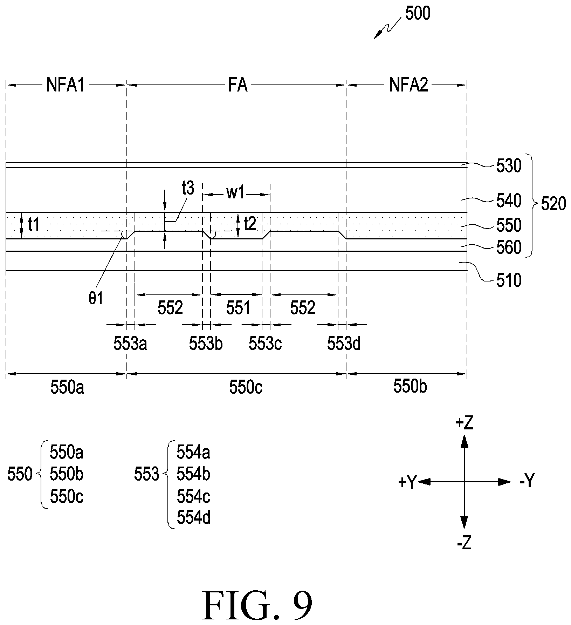

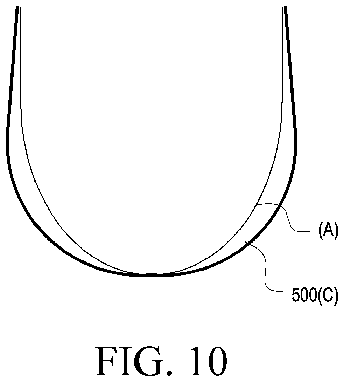

FIG. 9 is a schematic cross-sectional view taken along line A-A' of the display module 500 of FIG. 5 according to an embodiment of the disclosure. FIG. 10 is a view illustrating comparison between a folding shape of an electronic device 101 of FIG. 9 according to an embodiment of the disclosure and a folding shape of an electronic device 101 according to a comparative example.

Referring to FIGS. 9 and 10, in an embodiment, the display module 500 of the electronic device 101 may include a flexible display 510 and a display protection layer 520 disposed on the flexible display 510. The display protection layer 520 may include a coating layer 560 disposed on the flexible display 510, a glass layer 550 disposed on the coating layer 560, a soft protection film 540 disposed on the glass layer 550, and an outermost coating layer 530 disposed on the protection film 540.

Referring to FIGS. 9 and 10, the configuration of the electronic device 101, the housings 321 and 322, and the display module 500 of FIG. 5 may be identical in whole or part to the configuration of the configuration of the electronic device 101, the housings 321 and 322, and the display module 400 of FIGS. 6 to 8. The structure of FIGS. 9 and 10 may be selectively combinable with the structures of FIGS. 6 to 8.

In FIGS. 9 and 10, "Z" may be defined and interpreted as a thickness direction of the electronic device 101, and "Y" may be defined and interpreted as a length direction of the electronic device 101. In an embodiment of the present invention, 'Z' may mean a 3-1th direction (+Z direction) and a 3-2th direction (-Z direction). In an embodiment of the present invention, 'Y' may mean a 2-1th direction (+Y direction) and a 2-2th direction (-Y direction).

According to an embodiment of the present invention, the flat areas 550a and 550b of the glass layer 550 may have a single thickness. The thickness of the flat areas 550a and 550b may be defined as a first thickness t1. For example, the first thickness t1 may be about 55 μm or more and 65 μm or less. For example, the first thickness t1 may

be about 60 $\mu$m.

According to an embodiment of the disclosure, the thickness of the folding area 550c of the glass layer 550 may be formed to be smaller than the thickness of the flat area, thereby securing the strength of the folding area 550c and reducing the repulsive force. As the thickness of the glass layer 550 increases, impact-resistant performance may be enhanced. However, when the glass layer 550 is relatively too thick, folding may not be possible or damage may occur during folding. To compensate for this, the thickness of the folding area 550c may be formed to be smaller than the thickness of the flat area.

According to an embodiment of the present invention, the folding area 550c of the glass layer 550 may include a plurality of areas having different thicknesses. The thickness of a central portion of the folding area 550c of the glass layer 550 may be locally larger. At least a portion of the folding area 550c of the glass layer 550 may be configured to be folded or unfolded, and may include a first area 551 positioned in a central portion of the folding area 550c and a second area 552 extending from the first area 551 and connecting the first area 551 and the flat area. For example, the first area 551 may have a second thickness t2 different from the first thickness t1. For example, the second thickness t2 of the first area 551 may be smaller than the first thickness t1. For example, when the first thickness t1 is about 60 $\mu$m, the second thickness t2 may be about 35 $\mu$m or more and 45 $\mu$m or less. For example, the second thickness t2 may be about 40 $\mu$m. The second area 552 may have a third thickness t3 that is smaller than the second thickness t2. For example, the first area 551 may protrude in the 3-2th direction (e.g., the -Z direction of FIG. 6) as compared to the second area 552. For example, when the second thickness t2 is about 40 $\mu$m, the third thickness t3 may be about 28 $\mu$m or more and 34 $\mu$m or less. For example, the third thickness t3 may be about 31 $\mu$m. When the thickness of the central portion is locally increased, tensile and/or compressive stress and deformation concentrated in the central portion during folding may be dispersed without increasing the resistance to bending, thereby mitigating creases in the central portion of the electronic device 101.

According to an embodiment, referring to FIG. 9, the second thickness t2 of the first area 551 of the glass layer 550 may be larger than the third thickness t3. When the thickness of the second thickness t2 is relatively larger than the thickness of the third thickness t3, the repulsive force of the glass layer 550 against bending may increase, thereby affecting the folding of the electronic device 101. When the second thickness t2 is not relatively different from the third thickness t3, the effect of relieving stress may be weak.

According to an embodiment, referring to FIG. 9, the width length (e.g., the length in the Y-axis direction of FIG. 7) of the first area 551 of the glass layer 550 may be a portion of the folding area 550c. For example, it may be local. For example, it may be a first length w1. For example, when the second thickness t2 is about 40 $\mu$m and the third thickness t3 is about 31 $\mu$m, the first length w1 may be about 1 mm or more and 2 mm or less. For example, when the length of the folding area 550c of the glass layer 550 is about 10 mm, the first length w1 may be about 1 mm or more and 2 mm or less. When the first length w1 is relatively large, the repulsive force of the glass layer 550 against bending may increase, thereby affecting the folding of the electronic device 101. When the first length w1 is relatively short, the effect of relieving stress may be weak.

Referring to FIG. 10, a comparison in bending shape is made between when bending the electronic device 101 including the glass layer 550 (C) in which a portion of the folding area 550c is locally thick according to an embodiment of the present invention and when bending the electronic device A according to the comparative example. The radius of curvature may be larger when bending the electronic device 101 including the glass layer C in which a portion of the folding area 550c is locally thick according to an embodiment of the present invention than when bending the electronic device A of the comparative example. For example, when bending the glass layer A of the electronic device A of the comparative example, it is bent in an oval shape with a relatively small radius of curvature and, when bending the glass layer C in which a portion of the folding area 550c is locally thick, it may be bent in a circular shape with a relatively large radius of curvature.

[Table 2]

|  | A | C | Relaxation rate (%) |
|---|---|---|---|
| Maximum principal stress (MPa) | 1038 | 915 | 11.8 |
| Strain (1E-3) | 0.02371 | 0.02275 | 5.1 |

Referring to FIG. 10 and Equation 1, as compared to the electronic device A of the comparative example, the electronic device 101 including the glass layer 550 in which a portion of the folding area 550c is locally thick according to an embodiment of the present invention has a large radius of curvature and is given a relatively small stress and/or strain.

Table 2 is a table comparing the maximum principal stress and the maximum strain of the central portion of the electronic device 101 according to bending of the electronic device 101 according to FIG. 10. The maximum principal stress may be the maximum normal stress value. It may be identified that the central stress $\sigma$ of the glass layer C in which a portion of the folding area 550c is locally thick according to an embodiment of the present invention is alleviated as compared to the stress of the glass layer A of the general electronic device 101. For example, the stress in the central stress σ of the glass layer C in which a portion of the folding area 550c is locally thick according to an embodiment of the present invention, may be reduced by about 5% or more and 20% or less as compared to the stress of the glass layer A of the electronic device A of the comparative example. For example, the stress in the central stress σ of the glass layer C in which a portion of the folding area 550c is locally thick according to an embodiment of the present invention, may be reduced by about 11% or more and 13% as compared to the stress of the glass layer A of the electronic device A of the comparative example.

It may be identified that the central strain (1E-3) of the glass layer C in which a portion of the folding area 550c is locally thick according to an embodiment of the present invention is alleviated as compared to the strain (1E-3) of the glass layer A of the electronic device A of the comparative example. For example, the stress in the central strain (1E-3) of the glass layer C in which a portion of the folding area 550c is locally thick according to an embodiment of the present invention, may be reduced by about 2% or more and 7% or less as compared to the strain of the glass layer A of the electronic device A of the comparative example. For example, the stress in the central strain (1E-3) of the glass layer C in which a portion of the folding area 550c is locally thick according to an embodiment of the present invention, may be reduced by about 5% as compared to the strain (1E-3) of the glass layer A of the electronic device A of the comparative example.

According to an embodiment, the folding area 550c of the glass layer 550 may further include a connection portion 553 connecting a plurality of areas having different thicknesses. For example, the folding area 550c of the glass layer 550 may further include a connection portion 553b or 553c connecting the first area 551 and the second area 552. The connection portion 553b or 553c may connect the first area 551 having the second thickness t2 and the second area 552 having the third thickness t3. The connecting portion 553b or 553c may be disposed between the first area 551 having the second thickness t2 and the second area 552 having the third thickness t3. According to an embodiment, the connection portion 553b or 553c may include a straight line having an inclination according to the first angle θ1. The connection portion 553b or 553c may be positioned between a plurality of areas having different thicknesses and may have an inclination according to the first angle θ1. The first angle θ1 may be, e.g., an acute angle. The first angle θ1 may be, e.g., about 0 degrees or more and 90 degrees or less. However, the form and shape of the connection portion 553b or 553c are not limited to the above embodiment, and various changes may be made to the design.

According to an embodiment, for example, the folding area 550c of the glass layer 550 may further include a connection portion 553a or 553d connecting the flat area and the second area 552. The connection portion 553a or 553d may connect the flat area having the first thickness t1 and the second area 552 having the third thickness t3. The connecting portion 553a or 553d may be disposed between the flat area having the first thickness t1 and the second area 552 having the third thickness t3. According to an embodiment, the connection portion 553a or 553d may include a straight line having an inclination according to the second angle θ2. The connection portion 553a or 553d may be positioned between a plurality of areas having different thicknesses and may have an inclination according to the second angle θ2. The second angle θ2 may be, e.g., an acute angle. The second angle θ2 may be, e.g., about 0 degrees or more and 90 degrees or less. The second angle θ2 may be larger than, e.g., the first angle θ1. However, the form, shape, and/or angle of the connection portion 553a or 553d is not limited to the above embodiment, and various changes may be made to the design.

According to an embodiment, the coating layer 560 may correspond to the shape of the glass layer 550. For example, when the thickness of the glass layer 550 increases, the thickness of the coating layer 560 may decrease, and when the thickness of the glass layer 550 decreases, the thickness of the coating layer 560 may increase. For example, the thickness of the coating layer 560 in the portion corresponding to the first area 551 of the glass layer 550 may be smaller than the thickness of the coating layer 560 in the portion corresponding to the second area 552, which is thinner than the first area 551 of the glass layer 550. For example, the thickness of the coating layer 560 in the portion corresponding to the flat area of the glass layer 550 may be smaller than the thickness of the coating layer 560 in the portion corresponding to the folding area 550c (e.g., the first area 551 or second area 552), which is thinner than the flat area of the glass layer 550. According to an embodiment, the total thickness of the combined layer of the coating layer 560 and the glass layer 550 may be substantially constant. According to an embodiment, the overall thickness may be maintained constant by removing the thickness difference of the coating layer 560 by the thickness difference of the glass layer 550 having a plurality of thicknesses. According to an embodiment, the coating layer 560 may be a coating for filling. For example, the coating layer 560 may include an adhesive material such as an adhesive or resin.

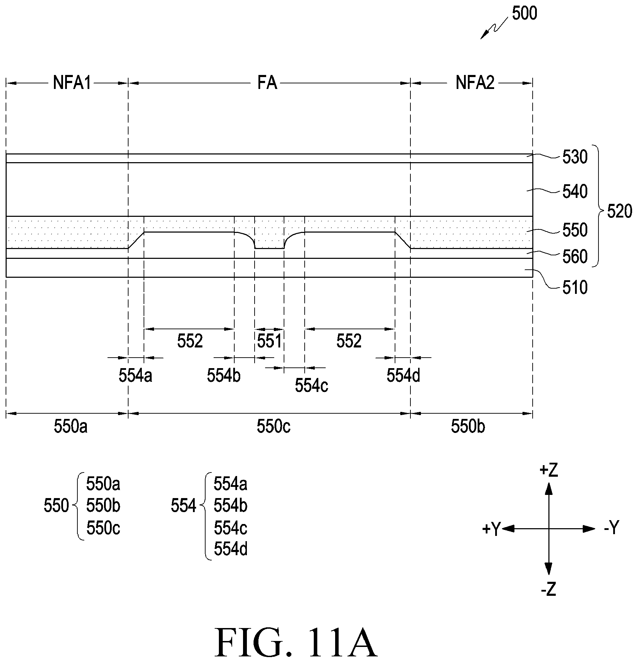

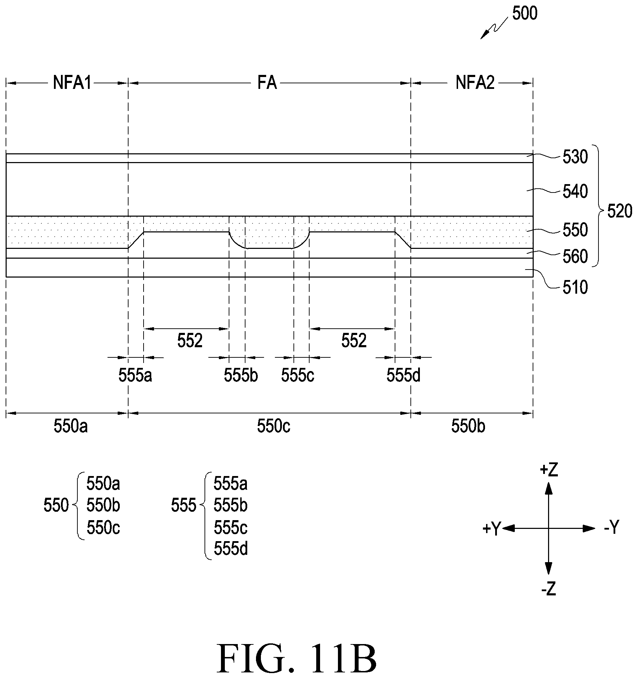

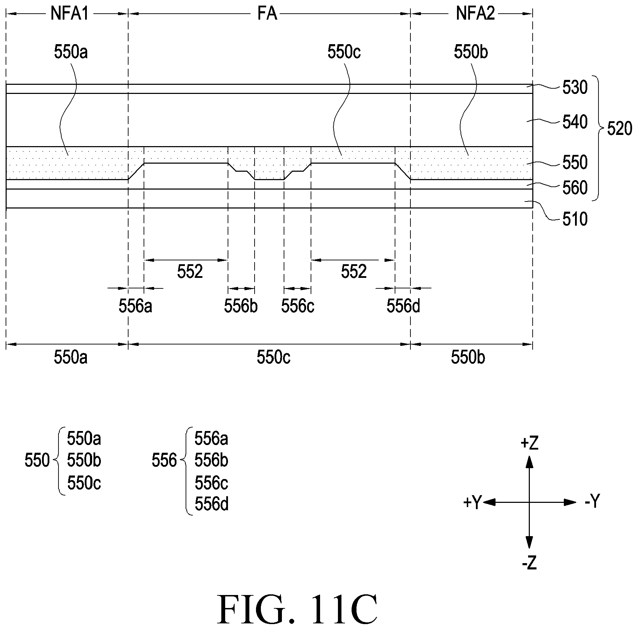

FIGS. 11A, 11B, and 11C are cross-sectional views schematically illustrating a partially modified connection portion 553 of the display module 500 of FIG. 9 according to an embodiment of the disclosure.

Referring to FIGS. 11A, 11B, and 11C, in an embodiment, the display module 500 of the electronic device 101 may include a flexible display 510 and a display protection layer 520 disposed on the flexible display 510. The display protection layer 520 may include a coating layer 560 disposed on the flexible display 510, a glass layer 550 disposed on the coating layer 560, a soft protection film 550 disposed on the glass layer 550, and an outermost coating layer 530 disposed on the protection film 550.

Referring to FIGS. 11A, 11B, and 11C, the configuration of the electronic device 101, the housings 321 and 322, and the display module 500 of FIGS. 11A, 11B, and 11C may be identical in whole or part to the configuration of the configuration of the electronic device 101, the housings 321 and 322, and the display module 500 of FIGS. 6 to 8. The structures of FIGS. 11A, 11B, and 11C may be selectively combinable with the structures of FIGS. 9 to 10.

In FIGS. 11A, 11B, and 11C, "Z" may be defined and interpreted as a thickness direction of the electronic device 101, and "Y" may be defined and interpreted as a length direction of the electronic device 101. In an embodiment of the present invention, 'Z' may mean a 3-1th direction (+Z direction) and a 3-2th direction (-Z direction). In an embodiment of the present invention, 'Y' may mean a 2-1th direction (+Y direction) and a 2-2th direction (-Y direction).

According to an embodiment, referring to FIGS. 11A, 11B, and 11C, the folding area 550c of the glass layer 550 may further include a connection portion 554, 555, or 556 connecting a plurality of areas having different thicknesses. For example, the folding area 550c of the glass layer 550 may further include a connection portion 554, 555, or 556 connecting the first area 551 and the second area 552. The connection portion 554, 555, or 556 may connect the first area 551 having the second thickness t2 and the second area 552 having the third thickness t3. The connecting portion 554, 555, or 556 may be disposed between the first area 551 having the second thickness t2 and the second area 552 having the third thickness t3. According to an embodiment, at least some of the connection portions 554, 555, and 556 may have a curved shape. For example, referring to FIG. 11A, the connection portions 554b and 554c may be curves convex in the 3-1th direction (e.g., the +Z direction of FIG. 11A). For example, the connection portions 554b and 554c may be curves convex in the 3-1th direction (e.g., the +Z direction of FIG. 11A), and the connection portions 554a and 554d may be curves convex in the 3-1th direction (e.g., the +Z direction of FIG. 11A) (not shown). For example, the connection portions 554b and 554c may be curves convex in the 3-1th direction (e.g., the +Z direction of FIG. 11A), and the connection portions 554a and 554d may be curves convex in the 3-2th direction (e.g., the -Z direction of FIG. 11A) (not shown). For example, referring to FIG. 11B, the connection portions 555b and 555c may be curves convex in the 3-2th direction (e.g., the -Z direction of FIG. 11B). For example, the connection portions 555b and 555c may be curves convex in the 3-2th direction (e.g., the -Z direction of FIG. 11B), and the connection portions 555a and 555d may be curves convex in the 3-1st direction (e.g., the +Z direction of FIG. 11B) (not shown). For example, the connection portions 555b and 555c may be curves convex in the 3-2th direction (e.g., -Z direction of FIG. 11B), and the connection portions 555a and 555d may be curves convex in the 3-2th direction (e.g., -Z direction of FIG. 11B) (not shown). For example, referring to FIG. 11C, the connection portions 556b and 556c may have a stepped shape in which a straight line parallel to the X-axis direction and a straight line having a designated inclination are connected. For example, the connection portions 556a, 556b, 556c, and 556d may have a stepped shape in which a straight line parallel to the X-axis direction and a straight line having a designated inclination are connected (not shown). For example, the connection portions 556b and 556c may have a stepped shape in which a straight line parallel to the X-axis direction and a straight line having a designated inclination are connected, and the connection portions 556a and 556d may be curves convex in the 3-2th direction (e.g., the -Z direction of FIG. 11C) (not shown). For example, the connection portions 556b and 556c may have a stepped shape in which a straight line parallel to the X-axis direction and a straight line having a designated inclination are connected, and the connection portions 556a and 556d may be curves convex in the 3-1th direction (e.g., the +Z direction of FIG. 11C) (not shown).

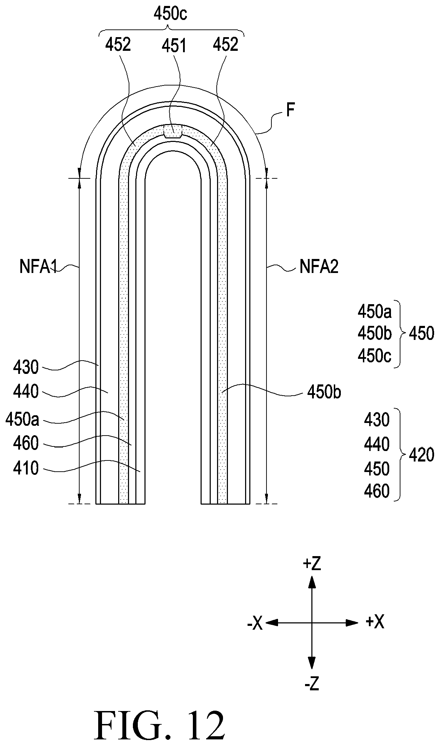

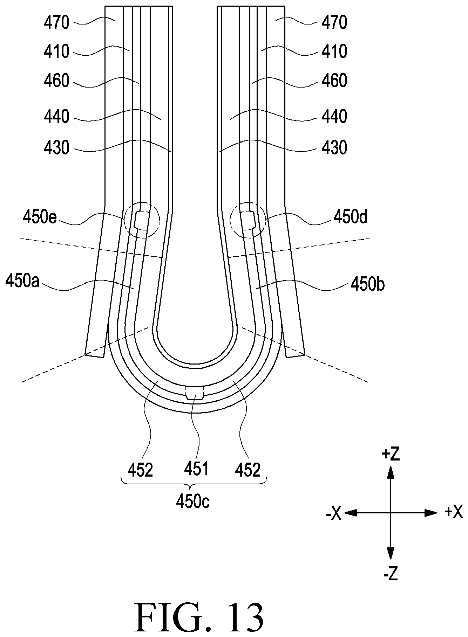

FIG. 12 is a cross-sectional view schematically illustrating an out-folded state of a display module 400 according to an embodiment of the disclosure. FIG. 13 is a cross-sectional view schematically illustrating an in-folded state and out-folded state of a display module 400 according to an embodiment of the disclosure.

Referring to FIGS. 12 and 13, in an embodiment, the display module 400 of the electronic device 101 may include a flexible display 410 and a display protection layer 420 disposed on the flexible display 410. The display protection layer 420 may include a coating layer 460 disposed on the flexible display 410, a glass layer 450 disposed on the coating layer 460, a soft protection film 440 disposed on the glass layer 450, and an outermost coating layer 430 disposed on the protection film 440.

Referring to FIGS. 12 and 13, the configuration of the electronic device 101, the housings 321 and 322, and the display module 400 of FIGS. 12 and 13 may be identical in whole or part to the configuration of the configuration of the electronic device 101, the housings 321 and 322, and the display module 400 of FIG. 11. The structure of FIGS. 12 and 13 may be selectively combinable with the structures of FIG. 11.

In FIGS. 12 and 13, "Z" may be defined and interpreted as a thickness direction of the electronic device 101, and "Y" may be defined and interpreted as a length direction of the electronic device 101. In an embodiment of the present invention, 'Z' may mean a 3-1th direction (+Z direction) and a 3-2th direction (-Z direction). In an embodiment of the present invention, 'Y' may mean a 2-1th direction (+Y direction) and a 2-2th direction (-Y direction).

According to an embodiment, the electronic device 400 may be implemented as two types, 'in-folding' in which the first display area 410a and the second display area 410b are folded to face each other, and 'out-folding' in which the first display area 410a and the second display area 410b are folded to face in opposite directions. For example, in the in-folding folded state, the first display area 410a and the second display area 410b may be substantially hidden and, in the fully unfolded state, the first display area 410a and the second display area 410b may be disposed to face substantially in the same direction. As another example, in the out-folding folded state, the first display area 410a and the second display area 410b are disposed to face in opposite directions, exposed to the outside and, in the fully unfolded state, the first display area 410a and the second display area 410b may be disposed to face substantially in the same direction.

According to an embodiment, referring to FIG. 12, when the electronic device 101 is out-folded, the first area 451 of the folding area 450c, which is a thickness reinforcing area, may be configured to protrude inward (e.g., in the -Z-axis direction of FIG. 12). When the first area 451 protrudes inward (e.g., in the -Z-axis direction of FIG. 12), the difference in touch sensation between the first area 451 and the second area 452 having different thicknesses may be reduced.

According to an embodiment, referring to FIG. 13, the electronic device 101 may include a plurality of folding areas. For example, a first folding area 450c, a second folding area 450d, and a third folding area 450e may be included. The plurality of folding areas may be in-folded or out-folded. For example, the first folding area 450c may be in-folded, the second folding area 450d, and the third folding area 450e may be out-folded. According to an embodiment, referring to FIG. 13, when the electronic device 101 is in-folded, the first area 451 of the first folding area 450c, which is a thickness reinforcing area, may be configured to protrude outward (e.g., in the - Z-axis direction of FIG. 13). When the first area 451 protrudes outward (e.g., in the -Z-axis direction of FIG. 13), the difference in touch sensation between the first area 451 and the second area 452 having different thicknesses may be reduced. According to an embodiment, referring to FIG. 13, when the electronic device 101 is out-folded, the second folding area 450d and the third folding area 450e, which are thickness reinforcing areas, may be configured to protrude inward with respect to the folding axis. For example, the second folding area 450d may be formed to protrude in the -X-axis direction of FIG. 13. For example, the third folding area 450e may be formed to protrude in the +X-axis direction of FIG. 13. However, the lengths of the protruding areas of the first folding area 450c, the second folding area 450d, and the third folding area 450e may be individually designated according to the thickness reinforcing amount and/or the tensile stress generated.

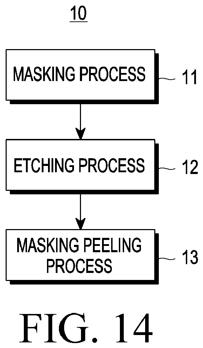

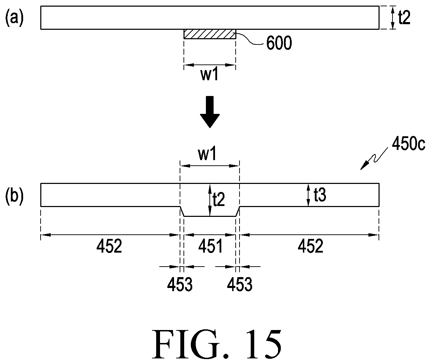

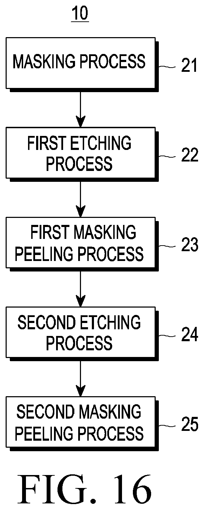

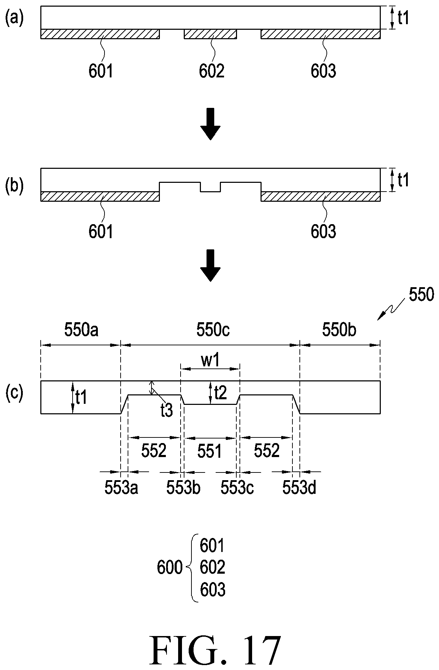

FIG. 14 is a flowchart illustrating a method for manufacturing the glass layer 450 of FIG. 6 according to an embodiment of the disclosure. FIG. 15 is a view illustrating a sequence of manufacturing a glass layer 450 according to the manufacturing method of FIG. 14 according to an embodiment of the disclosure. FIG. 16 is a flowchart illustrating a method for manufacturing the glass layer 450 of FIG. 9 according to an embodiment of the disclosure. FIG. 17 is a view illustrating a sequence of manufacturing a glass layer 450 according to the manufacturing method of FIG. 16 according to an embodiment of the disclosure.

Referring to FIGS. 14 to 16, in an embodiment, the display module 400 of the electronic device 101 may include a flexible display 410 and a display protection layer 420 disposed on the flexible display 410. The display protection layer 420 may include a coating layer 460 disposed on the flexible display 410, a glass layer 450 disposed on the coating layer 460, a soft protection film 440 disposed on the glass layer 450, and an outermost coating layer 430 disposed on the protection film 440.

Referring to FIGS. 14 to 16, the configuration of the electronic device 101, the housings 321 and 322, and the display module 400 of FIGS. 14 to 16 may be identical in whole or part to the configuration of the configuration of the electronic device 101, the housings 321 and 322, and the display module 400 of FIGS. 12 and 13. The structure of FIGS. 14 to 16 may be selectively combinable with the structures of FIGS. 12 and 13.

In FIGS. 14 to 16, "Z" may be defined and interpreted as a thickness direction of the electronic device 101, and "Y" may be defined and interpreted as a length direction of the electronic device 101. In an embodiment of the present invention, 'Z' may mean a 3-1th direction (+Z direction) and a 3-2th direction (-Z direction). In an embodiment of the present invention, 'Y' may mean a 2-1th direction (+Y direction) and a 2-2th direction (-Y direction).

Referring to FIGS. 14 to 16, a method of manufacturing the glass layer 450 formed to be thick in a local portion of the folding area 450c, which is a central portion of the glass layer 450 (e.g., thin film glass), is described.

According to the electronic device of the comparative example, it may be manufactured by any one of a computer numerical control (CNC) process and/or a polishing process. However, the computer numerical control (CNC) process or the polishing process may cause damage such as cracks and stripes due to wide thickness processing. An embodiment of the present invention relates to a method for manufacturing a glass layer (e.g., thin film glass) 450 through masking and/or etching using acid-resistant and/or alkali-resistant coating.

According to an embodiment, referring to FIG. 14, the method 10 for manufacturing the central reinforcing glass layer 450 of FIG. 6 may include a masking process 11, an etching process 12, and a masking peeling process 13.

According to an embodiment, the central reinforcing glass layer 450 of an embodiment (e.g., FIGS. 6 and 7) may be manufactured as shown in FIG. 15. The method 10 for manufacturing the central reinforcing glass layer 450 may include a masking 600 application process 11 and an etching process 12 on a portion other than the masking portion. According to the masking 600 application process 11, the masking 600 may be applied to the first area 451 of the folding area 450c of the glass layer 450 (FIG. 15(a)). The masking 600 may be an acid-resistant or base-resistant coating layer. The first thickness w1 may be adjusted by adjusting the printed width of the masking 600.

According to an embodiment, according to the etching process 12, the remaining portion other than the first area 451 to which the masking 600 is applied may be etched in the masking 600 application process S1 (FIG. 15(b)). In the etching process 12, a portion of the glass layer 450 to which the masking 600 is not applied may be immersed in an etching solution, thereby reducing the thickness of the remaining portion except for the first area 451. The etching solution may use, e.g., various acids and/or basic solutions. For example, any one of ammonium fluoride (NH4F), sulfuric acid (H2SO4), nitric acid (HNO3), silicon fluoride (H2SiF6), sodium hydroxide (NaOH), and hydrogen fluoride (HF) may be used as the etching solution. For example, the glass layer may be etched from the second thickness t2 to the third thickness t3 by the etching process 12. The thickness of the glass layer 450 may be reduced. A desired thickness reinforcing amount may be implemented by adjusting the third thickness t3 by adjusting the etching time.

According to an embodiment, the bending performance for the glass layer 450 manufactured by the method 10 for manufacturing the central reinforcing glass layer may be evaluate under certain conditions. A constant temperature and/or humidity may be required to evaluate bending performance. For example, the temperature may be 22°C or more and 27°C or less. For example, the temperature may be 25°C or less. For example, the humidity may be 45% or more and 55% or less. For example, the humidity may be 50%. Under these conditions, the glass layer 450 of about 0.4 mm or more and 10 mm or less may be bent without breakage for at least 60 minutes.

According to an embodiment, referring to FIG. 16, the method 20 for manufacturing the glass layer 550 of FIG. 9 may include a masking process 21, a first etching process 22, a first masking peeling process 23, a second etching process 24, and a second masking peeling process 25. Since the thickness w1 of the first area 551 is different from the thickness t1 of the flat areas 550a and 550b, it may be a manufacturing method for implementing different thicknesses.

According to an embodiment, the central reinforcing glass layer 550 of an embodiment (e.g., FIGS. 9 and 10) may be manufactured as shown in FIG. 17. A method for manufacturing the central reinforcing glass layer 550 may include a masking 600 process 21. According to the masking 600 process 21, the masking 600 may be applied to the first area 551 of the folding area 550c and the flat areas 550a and 550b of the glass layer 550 (a). The masking 600 may include first masking 601 and 603 applied to the flat areas 550a and 550b, and second masking 602 applied to the first area 551 of the folding area 550c. The masking 600 may be an acid-resistant or base-resistant coating layer. The first thickness w1 may be adjusted by adjusting the printed width of the masking 600. An etching process 22 on a portion other than the masking portion may be included.

According to an embodiment, according to the first etching process 22, the remaining portion other than the first area 551 to which the masking 600 is applied may be etched in the masking process 21. In the etching process 22, a portion of the glass layer 550 to which the masking 600 is not applied may be immersed in an etching solution, thereby reducing the thickness of the remaining portion except for the first area 551. The etching solution may use, e.g., various acids and/or basic solutions. For example, any one of ammonium fluoride (NH4F), sulfuric acid (H2SO4), nitric acid (HNO3), silicon fluoride (H2SiF6), sodium hydroxide (NaOH), and hydrogen fluoride (HF) may be used as the etching solution. For example, the glass layer 550 may be etched from a first thickness t1 to a third thickness t3 by the first etching process 22. The thickness of the glass layer 550 may be reduced. A desired thickness reinforcing amount may be implemented by adjusting the third thickness t3 by adjusting the etching time. For example, when the thickness t1 of the flat areas 550a and 550b is increased, the thickness difference between the folding area 550c and the flat areas 550a and 550b may be designed to be 20 μm or more in order to maintain the folding performance and to supplement the impact resistance performance of the flat areas 550a and 550b.

According to an embodiment, according to the first masking peeling process 23, only the second masking 602 may be peeled off (b).

According to an embodiment, according to the second etching process 24, the first area 551 in which the second masking 602 is peeled may be etched. For example, the first area 551 of the glass layer 550 may be etched from the first thickness t1 to the second thickness t2 by the second etching process 24. The thickness of the glass layer 550 may be reduced. A desired thickness reinforcing amount may be implemented by adjusting the second thickness t2 by adjusting the etching time. In this case, since the thickness reduction amount of the first area 551 is inevitably smaller than the thickness reduction amount of the second area 552, the thickness should be adjusted through the second etching process 24 after the first etching process 22.

According to an embodiment, in the second masking peeling process 25, the first masking 601 and 603 may be peeled off (c).

According to an embodiment, the bending performance for the glass layer 550 manufactured by the method 20 for manufacturing the central reinforcing glass layer may be evaluate under certain conditions. A constant temperature and/or humidity may be required to evaluate bending performance. For example, the temperature may be 22°C or more and 27°C or less. For example, the temperature may be 25°C or less. For example, the humidity may be 45% or more and 55% or less. For example, the humidity may be 50%. Under these conditions, the glass layer 450 of about 0.4 mm or more and 10 mm or less may be bent without breakage for at least 60 minutes.

[Table 3]

| Glass layer thickness (um) | Crack height | |
|---|---|---|
| | Pen drop(cm) | Pen press(kgf) |
| 30 | 6.3 | 0.33 |
| 40 | 16.3 | 0.56 |
| 60 | 22.6 | 1.05 |
| 100 | 100↑ | 2.46 |
| 110 | 100↑ | 2.90 |
| 120 | 100↑ | 3.59 |
| 130 | 100↑ | 4.03 |
| 140 | 100↑ | 5.04 |
| 150 | 100↑ | 5.69 |
| 160 | 100↑ | 6.14 |
| 170 | 100↑ | 7.06 |

Table 3 is a table showing the results of testing the durability of the glass layers 450 and 550. The first experiment is an experiment of measuring the height at which the glass layers 450 and 550 are damaged when the pen is dropped from a designated height to test the durability of the glass layers 450 and 550. The second experiment is an experiment of measuring a damaging load when the glass layers 450 and 550 are pressed with a designated load using a pen to test the durability of the glass layers 450 and 550. It was measured according to the thickness of the glass layers 450 and 550, and the thickness of the glass layer was set to 30 um or more and 170 um or less. For example, when the thickness of the glass layer is 30 um, the glass layer may be damaged when the pen is dropped from a height of 6.3 cm or more. In other words, when the thickness of the glass layer is 30 um, when the pen is dropped from a height of less than 6.3 cm, the glass layer may not be damaged. For example, when the thickness of the glass layer is 30 um, the glass layer may be damaged when the glass layers 450 and 550 are pressed with a load of 0.33 kgf or more using a pen. In other words, when the thickness of the glass layer is 30 um, and the glass layers 450 and 550 are pressed with a load of less than 0.33 kgf using a pen, the glass layer may not be damaged. The glass layers 450 and 550 according to the present invention are formed to be locally thicker, so that they are relatively flexible and durable.

When the electronic device is folded, compression and tensile stress may be generated in soft layers constituting the display module of the comparative example. The soft layers formed of polymer are vulnerable to plastic deformation, so that long-term or repetitive folding or a high temperature and/or high humidity environment may result in permanent deformation. This may leave creases, which may be visually and/or tactilely identified, in the folding area of the display module.

According to an embodiment of the present invention, the display protection layer 520 may include foldable glass layers 450 and 550 formed to be locally thicker, thereby mitigating creases in the center portion.

According to an embodiment of the disclosure, an electronic device may comprise a first housing (e.g., 321 of FIG. 5); a second housing (e.g., 322 of FIG. 5) configured to provide a motion relative to the first housing; a flexible display (e.g., 410 of FIG. 5; 510 of FIG. 9) configured to transform in response to the motion of the second housing relative to the first housing; and a display protection layer (e.g., 420 of FIG. 5 and 520 of FIG. 9) disposed on one surface of the flexible display facing in a first direction. The display protection layer may include a glass layer (e.g., 450 of FIG. 6, 550 of FIG. 9) including a flat area, which includes a first flat area (e.g., 450a of FIG. 6, 550a of FIG. 9) having a first thickness (e.g., t1 of FIG. 6) and disposed on the first housing, and a second flat area (e.g., 450b of FIG. 6, 550b of FIG. 9) disposed on the second housing, and a folding area (e.g., 450c of FIG. 6, 550c of FIG. 9) connecting the first flat area and the second flat area and a coating layer (e.g., 460 of FIG. 6, 560 of FIG. 9) disposed between the glass layer and the flexible display. The folding area of the glass layer may be configured to be at least partially folded or unfolded and include a first area (e.g., 451 of FIG. 7, 551 of FIG. 9) having a second thickness (e.g., t2 of FIG. 6) different from the first thickness and a second area (e.g., 452 of FIG. 7, 552 of FIG. 9) connecting the first area and the flat area and having a third thickness (e.g., t3 of FIG. 6) smaller than the second thickness. The first area may protrude in a second direction opposite to the first direction as compared with the second area.

According to an embodiment, a thickness of the folding area (e.g., 550c of FIG. 9) of the glass layer (e.g., 550 of FIG. 9) may be smaller than the first thickness (e.g., t1 of FIG. 9) of the flat area (e.g., 550a, 550b of FIG. 9).

According to an embodiment, the second thickness (e.g., t2 of FIG. 9) of the first area (e.g., 551 of FIG. 9) of the folding area may be smaller than the first thickness of the flat area.

According to an embodiment, the folding area may further include a connection portion (e.g., 553 of FIG. 9) shaped as a straight line inclined at a designated angle from one surface of the glass layer.

According to an embodiment, the folding area may include a curved connection portion (e.g., 554 of FIG. 11A).

According to an embodiment, the third thickness (e.g., t3 of FIG. 6) of the folding area (e.g., 450c of FIG. 6) may correspond to the first thickness (e.g., t1 of FIG. 6) of the flat area (e.g., 450a, 450b of FIG. 6).

According to an embodiment, the folding area may include a connection portion (e.g., 453 of FIG. 7) shaped as a straight line inclined at a designated angle from one surface of the glass layer (e.g., 450 of FIG. 6).

According to an embodiment, a shape of the coating layer (e.g., 460 of FIG. 6, 560 of FIG. 9) may correspond to a shape of the glass layer (e.g., 450 of FIG. 6, 550 of FIG. 9).

According to an embodiment, a combined layer of the coating layer and the glass layer may have a constant thickness.

According to an embodiment, the electronic device may further comprise a protection film (e.g., 440 of FIG. 6, 540 of FIG. 9) disposed on the glass layer.

According to an embodiment, the electronic device may further comprise an outermost coating layer (e.g., 430 of FIG. 6, 530 of FIG. 9) disposed on the glass layer.

According to an embodiment, the glass layer may include any one of polyimide (PI) or polyethylene terephthalate (PET).

According to an embodiment of the disclosure, an electronic device may comprise a first housing (e.g., 321 of FIG. 5), a second housing (e.g., 322 of FIG. 5) configured to provide a motion relative to the first housing, a flexible display (e.g., 510 of FIG. 9) configured to transform in response to the motion of the second housing relative to the first housing, and a display protection layer (e.g., 520 of FIG. 9) disposed on one surface of the flexible display facing in a first direction. The display protection layer may include a glass layer (e.g., 550 of FIG. 9) including a flat area, which includes a first flat area (e.g., 550a of FIG. 9) having a first thickness (e.g., t1 of FIG. 9) and disposed on the first housing, and a second flat area (e.g., 550b of FIG. 9) disposed on the second housing, and a folding area (e.g., 550c of FIG. 9) connecting the first flat area and the second flat area and a coating layer (e.g., 560 of FIG. 9) disposed between the glass layer and the flexible display. The folding area of the glass layer may be configured to be at least partially folded or unfolded and include a first area (e.g., 551 of FIG. 9) having a second thickness smaller than the first thickness and a second area (e.g., 552 of FIG. 9) connecting the first area and the flat area and having a third thickness (e.g., t3 of FIG. 9) smaller than the second thickness (e.g., t2 of FIG. 9). The first area may protrude in a second direction opposite to the first direction as compared with the second area.

According to an embodiment, the second thickness of the first area of the folding area may be smaller than the first thickness of the folding area.

According to an embodiment, the folding area may include a connection portion (e.g., 553 of FIG. 9) shaped as a straight line inclined at a designated angle from one surface of the glass layer.

According to an embodiment, the folding area may include a curved connection portion (e.g., 554 of FIG. 11A).

According to an embodiment, a shape of the coating layer (e.g., 460 of FIG. 6, 560 of FIG. 9) may correspond to a shape of the glass layer (e.g., 450 of FIG. 6, 550 of FIG. 9).

According to an embodiment, a combined layer of the coating layer and the glass layer may have a constant thickness.

According to an embodiment, the electronic device may further comprise a protection film (e.g., 440 of FIG. 6, 540 of FIG. 9) disposed on the glass layer.

According to an embodiment, the electronic device may further comprise an outermost coating layer (e.g., 430 of FIG. 6, 530 of FIG. 9) disposed on the glass layer. According to an embodiment, the display protection layer may have a radius of curvature of 0.2 mm or more and 12 mm or less for 60 minutes or more at a temperature of 22°C or more and 27°C or less, and a humidity of 45% or more and 55% or less.

It is apparent to one of ordinary skill in the art that the display module 400 and the electronic device 101 including the display module 400 according to various embodiments of the present invention as described above are not limited to the above-described embodiments and those shown in the drawings, and various changes, modifications, or alterations may be made thereto without departing from the scope of the present invention.

## Claims

1. An electronic device (e.g., 101 of FIG. 3) comprising:

a first housing (e.g., 321 of FIG. 5);
a second housing (e.g., 322 of FIG. 5) configured to provide a motion relative to the first housing; and
a flexible display (e.g., 410 of FIG. 5; 510 of FIG. 9) configured to transform in response to the motion of the second housing relative to the first housing; and
a display protection layer (e.g., 420 of FIG. 5 and 520 of FIG. 9) disposed on one surface of the flexible display facing in a first direction,
wherein the display protection layer includes:

a glass layer (e.g., 450 of FIG. 6, 550 of FIG. 9) including a flat area, having a first thickness (t1) includes a first flat area (e.g., 450a of FIG. 6, 550a of FIG. 9) disposed on the first housing and a second flat area (e.g., 450b of FIG. 6, 550b of FIG. 9) disposed on the second housing, and a folding area (e.g., 450c of FIG. 6, 550c of FIG. 9) connecting the first flat area and the second flat area; and
a coating layer (e.g., 460 of FIG. 6, 560 of FIG. 9) disposed between the glass layer and the flexible display, wherein the folding area of the glass layer includes a first area (e.g., 451 of FIG. 7, 551 of FIG. 9) having a second thickness (e.g., t2 of FIG. 6) different from the first thickness and a second area (e.g., 452 of FIG. 7, 552 of FIG. 9) connecting the first area and the flat area and having a third thickness (e.g., t3 of FIG. 6) smaller than the second thickness, and wherein the first area protrudes in a second direction opposite to the first direction as compared with the second area.

2. The electronic device of claim 1, wherein a thickness of the folding area (e.g., 550c of FIG. 9) of the glass layer (e.g., 550 of FIG. 9) is smaller than the first thickness (e.g., t1 of FIG. 9) of the flat area (e.g., 550a, 550b of FIG. 9).

3. The electronic device of claim 1 or 2, wherein the second thickness (e.g., t2 of FIG. 9) of the first area (e.g., 551 of FIG. 9) of the folding area is smaller than the first thickness of the flat area.

4. The electronic device of any one of claims 1 to 3, wherein the folding area further includes a connection portion (e.g., 553 of FIG. 9) shaped as a straight line inclined at a designated angle from one surface of the glass layer.

5. The electronic device of any one of claims 1 to 4, wherein the folding area includes a curved connection portion (e.g., 554 of FIG. 11A).

6. The electronic device of claim 1, wherein the third thickness (e.g., t3 of FIG. 6) of the folding area (e.g., 450c of FIG. 6) corresponds to the first thickness (e.g., t1 of FIG. 6) of the flat area (e.g., 450a, 450b of FIG. 6).

7. The electronic device of claim 6, wherein the folding area includes a connection portion (e.g., 453 of FIG. 7) shaped as a straight line inclined at a designated angle from one surface of the glass layer (e.g., 450 of FIG. 6).

8. The electronic device of any one of claims 1 to 7, wherein a shape of the coating layer (e.g., 460 of FIG. 6, 560 of FIG. 9) corresponds to a shape of the glass layer (e.g., 450 of FIG. 6, 550 of FIG. 9).

9. The electronic device of any one of claims 1 to 8, wherein a combined layer of the coating layer and the glass layer has a constant thickness.

10. The electronic device of any one of claims 1 to 9, further comprising a protection film (e.g., 440 of FIG. 6, 540 of FIG. 9) disposed on the glass layer.

11. The electronic device of any one of claims 1 to 10, further comprising an outermost coating layer (e.g., 430 of FIG. 6, 530 of FIG. 9) disposed on the glass layer.

12. The electronic device of any one of claims 1 to 11, wherein the glass layer includes any one of polyimide (PI) or polyethylene terephthalate (PET).

13. The electronic device of any one of claims 1 to 12, wherein the display protection layer has a radius of curvature of 0.2 mm or more and 12 mm or less for 60 minutes or more at a temperature of 22°C or more and 27°C or less, and a humidity of 45% or more and 55% or less.

14. An electronic device (e.g., 101 of FIG. 3) comprising:

a first housing (e.g., 321 of FIG. 5);
a second housing (e.g., 322 of FIG. 5) configured to provide a motion relative to the first housing; and
a flexible display (e.g., 510 of FIG. 9) configured to transform in response to the motion of the second housing relative to the first housing; and
a display protection layer (e.g., 520 of FIG. 9) disposed on one surface of the flexible display facing in a first direction,
wherein the display protection layer includes:

a glass layer (e.g., 550 of FIG. 9) including a flat area, having a first thickness(t1) includes a first flat area (e.g., 550a of FIG. 9) disposed on the first housing and a second flat area (e.g., 550b of FIG. 9) disposed on the second housing, and a folding area (e.g., 550c of FIG. 9) connecting the first flat area and the second flat area; and
a coating layer (e.g., 560 of FIG. 9) disposed between the glass layer and the flexible display,
wherein the folding area of the glass layer includes a first area (e.g., 551 of FIG. 9) having a second thickness smaller than the first thickness and a second area (e.g., 552 of FIG. 9) connecting the first area and the flat area and having a third thickness (e.g., t3 of FIG. 9) smaller than the second thickness (e.g., t2 of FIG. 9), and wherein the first area protrudes in a second direction opposite to the first direction as compared with the second area.

15. The electronic device of claim 14, wherein the second thickness of the first area of the folding area is smaller than the first thickness of the folding area.

FIG. 1

EP 4 332 947 A1

FIG. 2

EP 4 332 947 A1

101

260

220
210
213
220b
250
220
212
210
211

210
241
220
214
243

253
255
239
211
210
240
210b

FIG. 3

FIG. 4

321

A

NFA1

410a

FA

410c ⎫ 410

NFA2

410b

322

A'

321

+Y

-X ←→ +X

-Y

# FIG. 5

FIG. 6

FIG. 7

FIG. 8A

FIG. 8B

FIG. 9

(A)

500(C)

# FIG. 10

500

NFA1 — FA — NFA2

530
540
550
560
510
520

552    551    552

554a    554b    554c    554d

550a    550c    550b

550 { 550a
      550b
      550c

554 { 554a
      554b
      554c
      554d

+Z
+Y ← → -Y
-Z

# FIG. 11A

FIG. 11B

| NFA1 | FA | NFA2 |

550a        550c        550b

530
540        } 520
550
560
510

552        552

556a        556b    556c        556d

550a        550c        550b

550 { 550a 550b 550c    556 { 556a 556b 556c 556d

+Z
+Y ← → -Y
-Z

# FIG. 11C

FIG. 12

470 — 470
410 — 410
460 — 460
440 — 440
430 — 430

450e — 450d

450a — 450b

452  451  452
450c

+Z

-X ←→ +X

-Z

# FIG. 13

<u>10</u>

```
┌─────────────────────┐
│  MASKING PROCESS    │── 11
└─────────────────────┘
          │
          ▼
┌─────────────────────┐
│  ETCHING PROCESS    │── 12
└─────────────────────┘
          │
          ▼
┌─────────────────────┐
│  MASKING PEELING    │── 13
│     PROCESS         │
└─────────────────────┘
```

# FIG. 14

(a) t2

600

w1

w1

(b) t2 t3 450c

452 451 452

453 453

# FIG. 15

10

```
┌─────────────────────┐
│  MASKING PROCESS    │── 21
└─────────────────────┘
          │
          ▼
┌─────────────────────┐
│   FIRST ETCHING     │── 22
│      PROCESS        │
└─────────────────────┘
          │
          ▼
┌─────────────────────┐
│   FIRST MASKING     │── 23
│  PEELING PROCESS    │
└─────────────────────┘
          │
          ▼
┌─────────────────────┐
│   SECOND ETCHING    │── 24
│      PROCESS        │
└─────────────────────┘
          │
          ▼
┌─────────────────────┐
│   SECOND MASKING    │── 25
│  PEELING PROCESS    │
└─────────────────────┘
```

FIG. 16

(a)

601  602  603

(b)

601  603

550

550a  550c  550b

w1

(c)

t1  t3  t2

552  551  552

553a  553b  553c  553d

$600 \begin{cases} 601 \\ 602 \\ 603 \end{cases}$

# FIG. 17

<div align="center">

**INTERNATIONAL SEARCH REPORT**

</div>

| | International application No. |
|---|---|
| | **PCT/KR2023/009437** |

| A. | CLASSIFICATION OF SUBJECT MATTER |
|---|---|

**G09F 9/30**(2006.01)i; **G06F 1/16**(2006.01)i; **H04M 1/02**(2006.01)i; **H10K 102/00**(2023.01)i

According to International Patent Classification (IPC) or to both national classification and IPC

| B. | FIELDS SEARCHED |
|---|---|

Minimum documentation searched (classification system followed by classification symbols)

G09F 9/30(2006.01); C03B 23/03(2006.01); C03C 17/00(2006.01); C03C 17/32(2006.01); G02B 1/14(2015.01); G02B 5/30(2006.01); H04M 1/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 플렉서블 디스플레이(flexible display), 디스플레이 보호층(display protective layer), 유리층(glass layer), 코팅층(coating layer), 폴딩 영역(folding area), 두께(thickness)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-2022-0079401 A (SAMSUNG ELECTRONICS CO., LTD.) 13 June 2022 (2022-06-13)<br>See paragraphs [0116], [0130] and [0134]; and claims 1, 17, 21 and 25. | 1-15 |
| A | KR 10-2020-0124059 A (SAMSUNG ELECTRONICS CO., LTD.) 02 November 2020 (2020-11-02)<br>See paragraphs [0069]-[0071]. | 1-15 |
| A | KR 10-2020-0008727 A (SAMSUNG ELECTRONICS CO., LTD.) 29 January 2020 (2020-01-29)<br>See paragraph [0017]. | 1-15 |
| A | KR 10-2022-0067764 A (SAMSUNG ELECTRONICS CO., LTD.) 25 May 2022 (2022-05-25)<br>See paragraphs [0020]-[0021]. | 1-15 |
| A | KR 10-2017-0087002 A (PARK, Hyun Min) 27 July 2017 (2017-07-27)<br>See claim 1. | 1-15 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 October 2023** | **13 October 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/009437**

| Patent document cited in search report | | | Publication date (day/month/year) | Patent family member(s) | | | Publication date (day/month/year) |
|---|---|---|---|---|---|---|---|
| KR | 10-2022-0079401 | A | 13 June 2022 | None | | | |
| KR | 10-2020-0124059 | A | 02 November 2020 | None | | | |
| KR | 10-2020-0008727 | A | 29 January 2020 | KR | 10-2553885 | B1 | 11 July 2023 |
| KR | 10-2022-0067764 | A | 25 May 2022 | WO | 2022-108189 | A1 | 27 May 2022 |
| KR | 10-2017-0087002 | A | 27 July 2017 | KR | 10-2017-0087001 | A | 27 July 2017 |
| | | | | KR | 10-2477191 | B1 | 15 December 2022 |
| | | | | KR | 10-2477192 | B1 | 15 December 2022 |

Form PCT/ISA/210 (patent family annex) (July 2022)